(19) Europäisches Patentamt
European Patent Office
Office européen des brevets

(11) EP 3 910 691 A1

(12) **EUROPEAN PATENT APPLICATION**
published in accordance with Art. 153(4) EPC

(43) Date of publication:
**17.11.2021 Bulletin 2021/46**

(21) Application number: **20739110.3**

(22) Date of filing: **07.01.2020**

(51) Int Cl.:
***H01L 51/05*** *(2006.01)*

(86) International application number:
**PCT/CN2020/070696**

(87) International publication number:
**WO 2020/143624 (16.07.2020 Gazette 2020/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.01.2019 CN 201910013583**

(71) Applicant: **Neudrive Limited**
**Buxton**
**SK17 6JR (GB)**

(72) Inventors:
- **FENG, Linrun**
  **Wuhan 430071 (CN)**
- **LIU, Zhe**
  **Wuhan City 430070 (CN)**
- **RAJEEV, Kiron Prabha**
  **Buxton SK17 6JR (GB)**
- **PANDYA, Shashi Urvish**
  **Durham DH1 5HF (GB)**
- **OGIER, Simon Dominic**
  **Ripon, Yorkshire HG4 1SP (GB)**

(74) Representative: **Murgitroyd & Company**
**Murgitroyd House**
**165-169 Scotland Street**
**Glasgow G5 8PL (GB)**

(54) **PREPARATION AND LAYER**

(57) Described is a flowable preparation for depositing a passivation layer on an organic electronic (OE) device containing an organic layer; the organic layer is selected from an organic semiconductor (OSC) layer and an organic gate insulator (OGI) layer; the preparation comprises a passivating material and a solvent; the solvent includes lactate and/or derivatives thereof. Further described are an OE device and a manufacture method therefor.

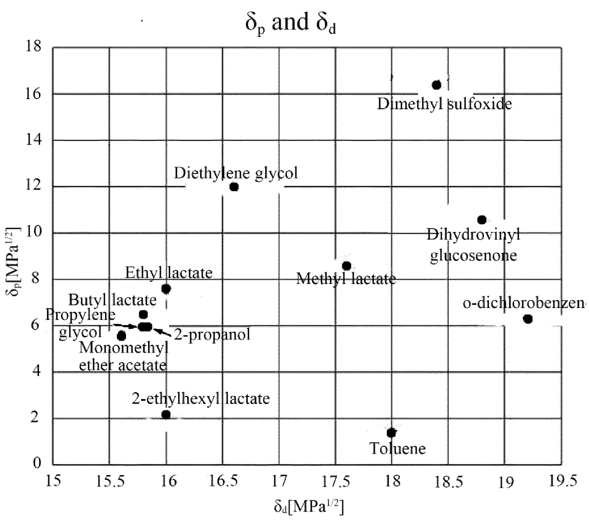


FIG. 2A

EP 3 910 691 A1

## Description

Technical Field

The present application relates, but is not limited, to formulations for providing layers, such as passivation layers and/or photopatterning layers, for use in fabrication of organic electronic devices, to methods of fabrication of organic electronic devices using such formulations, and to organic electronic devices including the layers provided by such formulations.

Background

Organic electronic (OE) devices include, for example, an organic field effect transistor (OFET) for use in backplanes of display devices or logic capable circuits, and organic photovoltaic (OPV) devices. A conventional top gate OFET comprises source and drain electrodes, a semiconductor layer made of an organic semiconductor (OSC) material, a gate insulator layer made of a dielectric material (also known as a dielectric or a gate dielectric) such as an organic gate insulator (OGI), a gate electrode, and typically a passivation layer on the top of the OGI layer to protect the OSC and OGI layers against environmental influence and/or damage from subsequent device manufacturing steps. Similarly, a conventional bottom gate OFET comprises a gate electrode, a gate insulator layer made of a dielectric material such as an organic gate insulator (OGI), source and drain electrodes, a semiconducting layer made of an organic semiconductor (OSC) material, and typically a passivation layer on the top of the OSC layer to protect the OSC and OGI layers against environmental influence and/or damage from subsequent device manufacturing steps. In both the top and the bottom gate OFETs, the passivation layer may also serve as an interlayer dielectric, so that, for example, metal tracks may be routed in the circuits on different layers of these OE devices without short circuiting.

Conventional fabrication techniques of these OE devices are based on processes that include, for example, thermal evaporation, chemical or physical vapor deposition, solution coating or printing and photolithography. Solution processable passivation layers are preferable, particularly for OFETs. Solution processable passivation materials (SPPMs) allow utilisation of solution-based deposition methods, for example, spin coating or larger area printing methods including flexo, gravure and slot-die coating, during fabrication. Adherence of a passivation materials to underlying layers may be a primary conventional requirement for such solution-based passivation materials. In addition, orthogonality of solvents used in the solution-based passivation materials, particularly to organic layers such as the OSC layers and/or OGI layers, is also required. Generally, the orthogonality of the solvents may be understood as chemical orthogonality. For example, an orthogonal solvent is a solvent which, when used to provide a layer of a material dissolved and/or dispersed in it on a previously provided layer, does not adversely affect these previously provided layers. Thus, orthogonal solvents may be considered as suitable (also known as compatible) solvents, in that they do not adversely affect organic layers such as the OSC layers and/or the OGI layers. In contrast, non-orthogonal (also known as unsuitable or incompatible) solvents may dissolve, damage, destroy or impact the long-term stability of the previously provided layer. However, while the orthogonal solvents may be compatible with the organic layers such as the OSC layers and/or the OGI layers, dissolution and/or dispersion of the passivation materials therein may be problematic.

Figs. 1A and 1B show schematically a method of fabrication of an OE device, specifically, a top gate OFET, using conventional solution processable passivation materials. Typically, such a method of fabrication may be achieved practically by a photolithographic processing, as known to the person skilled in the art.

At S101, a substrate 110 is provided. The substrate 110 may comprise, for example, glass, metal, a polymer, or an integrated circuit (IC). The substrate 110 may include an optional buffer layer provided on the surface of the substrate 110. The buffer layer, which may also be known as a planarization layer, is provided by a cross-linkable polymer that may improve surface uniformity and/or homogeneity by smoothing defects in the surface of the substrate and may provide a chemically inert surface upon which an OE device is fabricated.

At S102, source and drain electrodes 120 are provided on the surface of the substrate 110, for example by sputtering and photolithography (using mask 1). The source and drain electrodes 120 are typically metal, for example silver or gold or alloys thereof, or non-metal. The source and drain electrodes 120 may be treated with a thiol solution, to adjust work functions of the source and drain electrodes 120, as known in the art. In this way, injection of charges into an overlapping OSC layer may be improved. Excess thiol solution may be washed away, with thiol being bound only to the source and drain electrodes 120.

At S103, firstly, an OSC layer 130 is provided on the source and drain electrodes 120 and the exposed surface of the substrate 110, for example, by spin coating or printing. The OSC layer 130 typically has a thickness of 30 nm. An OGI layer 140 is subsequently provided on the OSC layer 130, for example, by spin coating or printing. The OGI layer 140 has typically a thickness of 300 nm. A metal layer 150, which is, for example, silver or gold or alloys thereof, is subsequently deposited on the OGI layer 140, for example, by evaporation. A photoresist (not shown) is subsequently patterned (e.g., by photolithography) on the metal layer 150 and portions of the metal layer 150 exposed through the

patterned photoresist are removed by wet etching. The patterned metal layer 150 provides a gate, such as a thin film transistor (TFT) gate. The patterned metal layer 150 also provides a hardmask (mask 2) against reactive ion etching (RIE) (also known as dry etching, using, for example $O_2$ and/or Ar), thereby masking the underlying OGI layer 140, the OSC layer 130, and the source and the drain electrodes 120. Subsequently, RIE removes portions of the OGI layer 140 and the OSC layer 130, that are not masked by the patterned metal layer 150. In this way, a stack 100 comprising the patterned metal layer 150, the OGI layer 140, the OSC layer 130, and the source and the drain electrodes 120 is provided on the substrate 110. It should be understood that stack 100 generally describes a multilayered structure and thus may comprise more or fewer and/or different layers. For example, stack 100 may comprise these layers at an intermediate stage of fabrication of an OE device. For example, stack 100 may comprise all the layers of the completed OE device. Thus, layers included in the stack 100 may change during manufacturing, by addition and/or by removal of layers. Sides 141 of the OGI layer 140 and sides 131 of the OSC layer 130 may be thus exposed to, for example, RIE, and may be adversely affected by unsuitable solvent. Further, inter-layer interfaces, for example, those between the substrate 110 and the OSC layer 130, between the OSC layer 130 and the OGI layer 140, and/or between the OGI layer 140 and the metal layer 150, may also be exposed. Other surfaces of the OGI layer 140 and/or the OSC layer 130 may be additionally and/or alternatively exposed.

At S104, a conventional first passivation layer 180 is provided on the stack 100 and the exposed surface of the substrate 110, for example, by coating with the first formulation comprising an aqueous solution of a water-soluble polymer formulation such as polyvinyl alcohol (PVA) plus Ammonium Dichromate (ADC) and subsequently UV crosslinking the water-soluble polymer (i.e., PVA+ADC). The first passivation layer 180 has typically a thickness of 100 nm. Water is generally considered as an orthogonal solvent, being at least sufficiently compatible with the OGI layer 140 and/or the OSC layer 130. However, the first passivation layer 180 provided using crosslinked PVA may not be suitable for subsequent fabrication steps and/or may not be suitable for providing environmental, chemical and/or physical protection for the fabricated OE device. Hence, a second passivation layer 190 is additionally required, as described below.

At S105, a positive photoresist mask 181 (mask 3) is provided on the first passivation layer 180.

At S106, the first hole 185 (also known as a via) is formed through the first passivation layer 180 to reach the patterned metal layer 150, by RIE through the positive photoresist mask 181, thereby exposing at least a part of the surface of the metal layer 150.

At S107, residual photoresist mask 181 is removed.

At S108, the second passivation layer 190 is provided on the first passivation layer 180 and the exposed portions of the stack, such as the patterned metal layer 150 exposed through the hole formed through the first passivation layer 180. The second passivation layer 190 is provided by, for example, coating with a second formulation, such as a solution of another cross-linkable polymer, for example SU-8 available from Microchem Corp., Westborough, MA. (USA), and crosslinking the polymer. SU-8 comprises a bisphenol A novolac epoxy dissolved in an organic solvent such as cyclopentanone, gamma-butyrolactone (GBL) or propylene glycol monoethyl ether acetate (PGMEA). SU-8 may include also up to 10wt.% of photoacid generator, for example, a mixed triarylsulfonium hexafluoroantimonate. The second passivation layer 190 has typically a thickness of 300 nm and may provide the main passivation layer for an OE device. The second passivation layer 190, comprising the crosslinked polymer, thus overlays the first passivation layer 180, comprising crosslinked PVA. The second passivation layer 190 provides the robustness required to ensure environmental, chemical and/or physical protection of the fabricated OE device.

The organic solvents used in the second formulation are generally non-orthogonal solvents, being incompatible with the organic layers, such as the OGI layer 140 and/or the OSC layer 130, of the stack 100. However, robust cross-linkable polymer, such as in SU-8, maynot be soluble and/or dispersible in orthogonal solvents, such as water used in the first formulation, and thus must be provided in these non-orthogonal solvents, such as cyclopentanone, GBL or PGMEA. Hence, the first passivation layer 180 acts as a protective layer, protecting the organic layers, such as the OGI layer 140 and/or the OSC layer 130, of the stack 100 from the non-orthogonal solvents included in the second formulation.

A second hole 195 or via, aligned with the first hole formed through the first passivation layer 180, is subsequently formed through the second passivation layer 190 towards the patterned metal layer 150, thereby exposing at least a part of the surface of the metal layer 150, as similarly described with at steps S105 to S107 with respect to the first passivation layer 190. Another positive photoresist mask (not shown) (mask 4) is provided on the second passivation layer 190, and the hole, or via, is formed therethrough by RIE. Residual photoresist mask is subsequently removed.

At S109, a metal gate interconnect 170 is provided through the second hole to the patterned metal layer 150, for example, by sputtering, masking (mask 5) and etching.

In this way, the OE device may be provided, having a double passivation layers comprising the first passivation layer 180 and the second passivation layer 190.

However, utilisation of this double passivation layer comprising the first passivation layer 180 and the second passivation layer 190 increases OE device fabrication complexity and/or cost. Furthermore, water-soluble polymers, such as PVA, are hygroscopic and water, as an absorbed moisture, in the first passivation layer 180 may be detrimental to long-term stability of OE devices. In addition, according to this conventional method of fabrication of the OE device,

five masks (mask 1 to mask 5) are required.

Thus, there is a need to provide improved fabrication of OE devices, for example, with respect to provision of passivation layers and/or photopatterning layers.

## Summary of Invention

The following is a summary of the subjects described herein in detail. This summary is not intended to limit the scope of protection of this application.

The present application amongst others provides a formulation for making passivation layers and/or photopatterning layers to be used in fabrication of organic electronic devices, which may be aaplied, for example, directly on organic layers, such as OSC layers and/or OGI layers and/or on a stack comprising one or more of these layers. The present application also provides methods of fabrication of organic electronic devices, using such formulations, which have reduced complexity and/or cost. The present application further provides organic electronic devices, which have layers provided by such formulations and improved long-term stability.

The first aspect of the application provides a flowable formulation for depositing a passivation layer on an organic electronic (OE) device comprising an organic layer, wherein the organic layer is selected from an organic semiconductor (OSC) layer and an organic gate insulator (OGI) layer, wherein the formulation comprises a passivation material and a solvent;
wherein the solvent comprises lactate and/or a derivative thereof.

The second aspect of the present application provides a method of fabrication of an organic electronic (OE) device comprising an organic layer, wherein the organic layer is selected from an organic semiconductor (OSC) layer and an organic gate insulator (OGI) layer, wherein the method comprises: providing a passivation layer on at least a part of the organic layer by depositing the formulation according to the first aspect theron and removing the solvent.

The third aspect of the application provides an organic electronic (OE) device comprising an organic layer and a passivation layer directly thereon, wherein the organic layer is selected from an organic semiconductor (OSC) layer and an organic gate insulator (OGI) layer and wherein the passivation layer comprises a cross-linked product of a cross-linkable composition provided by the first aspect.

The fourth aspect of the present application provides a product comprising an organic electronic (OE) device fabricated according to the second aspect and/or an OE device according to the third aspect.

The fifth aspect of the present application provides a flowable formulation comprising a photopatterning material and a solvent;
wherein the solvent comprises lactate and/or a derivative thereof.

The sixth aspect of the present application provides the use of a solvent comprising lactate and/or a derivative thereof in a method of fabrication of an organic electronic (OE) device comprising an organic layer, wherein the organic layer is selected from an organic semiconductor (OSC) layer and an organic gate insulator (OGI) layer.

Additional features and advantages of the application will be set forth in the following description, and in part will become clearer from the description, or may be understood by practicing the application. The objects and other advantages of the present application can be realized and obtained by the structure particularly indicated in the specification, claims and drawings.

## Brief Description of Drawings

To enhance the understanding of the present application, and to show how exemplary embodiments of the same may be brought into effect, referencing to the accompanying drawings will be made, by examples only, in which:

- Figs. 1A and 1B show schematically a method of fabrication of an OE device using conventional solution processible passivation materials;
- Figs. 2A to 2C depict schematically a 2D Hansen solubility parameter map of lactate solvents and other solvents;
- Figs. 3A and 3B show schematically a method of fabrication of an OE device according to an embodiment of aspects of the present application;
- Fig. 4 shows schematically another method of fabrication of an OE device according to an embodiment of aspects of the present application;
- Figs. 5A to 5F show a series of designs for transistor source-drain electrodes.

These include (Fig. 5A) Corbino structure, (Fig. 5B) C-shape, (Fig. 5C) W-shape, (Fig. 5D) linear, (Fig. 5E) linear cross design of source and drain electrodes. In (Fig. 5F), a gate metal layer associated with the source and the drain electrodes is also shown. If the solvent of the passivation layer is selected inappropriately, the conductive channel in OTFT will be sensitive to erosion by the solvent because the edge of the gate metal is very close to the conductive channel. The

conductive channel region is not affected by the lactate solvents of the present application, as shown by the electrical results in the section of the examples.

Figs. 6A and 6B show the transfer characteristics and the mobility curve data for a linear OE device with W/L of 9800/12 (microns) after deposition of a passivation layer of ethyl lactate and deposition and patterning of a metal interconnection layer. A high on/off ratio and a subthreshold swing as low as 0.3V/decade can be seen in the transfer curve. Figs. 6C and 6D show the transmission characteristics and the mobility curve data for the linear OE device, respectively, with W/L of 200/12 (microns) and a subthreshold swing of 1V/decade.

Figs. 7A and 7B show the transfer characteristics and the mobility curve data for a linear OE device with W/L of 200/12 (microns) after deposition of the passivation layer from Cyrene and deposition and patterning of a metal interconnection layer, respectively. A low on/off ratio and a subthreshold swing as high as 15V/decade can be clearly seen in the transfer curve.

Detailed Description

Hereinafter, the embodiments of the present application will be described in detail. It should be noted that the embodiments in the present application and the features in the embodiments can be arbitrarily combined with each other without conflict.

According to the present application, there are provided formulations, methods and organic electronic (OE) device as described above. Other features of the present application will be apparent from the description that follows.

Throughout this application, the term "comprising" or "comprises" means including the component(s) specified, but not excluding the presence of other components. The term "consisting essentially of" or "consists essentially of" means including the components specified but excluding other components except for materials present as impurities, unavoidable materials present because of the processes used to provide the components, and components added for a purpose other than achieving the technical effect of the present application.

The term "consisting of" or "consists of" means including the components specified but excluding other components.

Where appropriate, depending on the context, the use of the term "comprises" or "comprising" may also be taken to include the meanings of "consists essentially of" or "consisting essentially of', and may also be taken to include the meanings of "consists of" or "consisting of'.

The optional features set out herein may be used either individually or in combination with each other where appropriate and particularly in the combinations as set out in the appended claims. The optional features for each aspect or exemplary embodiment of the present application, as set out herein are also applicable to all other aspects or exemplary embodiments of the present application, where appropriate. In other words, a skilled person reading this specification should consider the optional features for each aspect or exemplary embodiment of the present application as interchangeable and combinable between different aspects and exemplary embodiments.

Development of SPPMs is challenged by conflicting requirements, as outlined above.

The SPPMs and/or formulations should preferably be compatible with (i.e., orthogonal to) organic layers, such as the OSC layers and/or OGI layers, and OE device architectures. However, the organic layers may be soluble in organic solvents, and hence exposure of these organic layers to such solvents should be avoided. In addition, interlayer adhesion, such as an adhesion between overlapping OSC and/or OGI layers, is important for functioning of OE devices. Since different organic layers, such as the OSC and/or OGI layers, have typically different surface energies, solvents that may not dissolve a particular layer may penetrate via the inter-layer interfaces, and thereby also degrade or destroy functioning of OE devices.

Furthermore, the SPPMs should preferably provide environmental, physical and/or chemical resistance, for example against materials and conditions applied in the subsequent fabrication steps during OE device manufacture, for example photolithography. Typically, photolithography includes one or more of the following processing steps, which may involve chemical and/or physical exposure of the underlying layer: deposition of photoresist resin, typically in an organic solvent; UV exposure; development of the photoresist, typically using bases; etching of metal, typically using aggressive acid and redox reactions; and/or removal of the photoresist, typically using aggressive organic solvents.

Hence, the deposited passivation material should preferably be resistant to organic solvents and/or aqueous solutions. However, as a conflicting requirement, deposition of a passivation material generally requires the passivation material to preferably be soluble and/or dispersible in an organic solvent or in an aqueous solution. Thus, the passivation material may be cross-linked after deposition, for example, to meet these conflicting requirements.

The deposited passivation layer should preferably exhibit at least one of the following properies: mechanical flexibility, good scratch resistance, thermal stability, optical transparency, uniformity, pinhole free, good adhesion to other layers, good barrier properties with respect to water and/or oxygen, non-hygroscopic and good dielectric breakdown strength.

### *Formulation*

The first aspect of the present application provides a flowable formulation for depositing a passivation layer on an organic electronic (OE) device comprising an organic layer, wherein the organic layer is selected from an organic semiconductor (OSC) layer and an organic gate insulator (OGI) layer, wherein the formulation comprises a passivation material and a solvent;
wherein the solvent comprises lactate and/or a derivative thereof.

One aspect of the present application provides a flowable formulation comprising a passivation material and a solvent;
wherein the solvent comprises lactate and/or a derivative thereof.

For example, the flowable formulation according to the first aspect of the present application may also be suitable for providing layers in other devices, such as microelectromechanical systems (MEMs), microfluidic devices and/or conventional (for example, a non-organic thin film transistor (OTFT)) electronics.

According to an aspect of the present application, there is also provided a flowable formulation comprising a photopatterning material and a solvent;
wherein the solvent comprises lactate and/or a derivative thereof.

In this way, direct photopatterning on an organic electronic (OE) device comprising an organic layer, wherein the organic layer is selected from an organic semiconductor (OSC) layer and an organic gate insulator (OGI) layer, may be provided. In this way, RIE etching may be avoided, thereby, for example, reducing the cost and/or complexity of fabrication of OE devices.

According to an aspect of the present application, there is also provided a flowable formulation comprising a cross-linkable composition and a solvent;
wherein the solvent comprises lactate and/or a derivative thereof.

Generally, the flowable formulation may be applied for spin coating and/or printing directly and/or subsequent addition of additional solvents. Generally, flowable formulations, for example, for spin coating, may have dynamic or absolute viscosities in a range from 1 to 10,000 centipoises or more, as known to the person skilled in the art. In one example, a dynamic viscosity of the flowable formulation is in a range from 1 to 10,000 centipoises, preferably 1 to 1,000 centipoises, and more preferably 1 to 20 centipoises. A dynamic viscosity of the flowable formulation may depend, at least in part, on an amount of the solvent in the flowable formulation in such a way that an increased amount of the solvent may decrease the dynamic viscosity.

In the present application, the lactate and or derivatives thereof include L-lactate and or derivatives thereof, or D-lactate and or derivatives thereof, or a mixture of L-lactate and or derivatives thereof and D-lactate and or derivatives thereof, preferably a mixture of L-lactate and or a derivative thereof and D-lactate and or a derivative thereof in a ratio of 1:1 (also known as a racemic mixture).

The inventors have determined that lactate and/or a derivative thereof may substitute for conventional organic solvents, such as cyclopentanone, GBL or PGMEA, for example, in SU-8, as described above in relation to the second passivation layer.

Surprisingly, the inventors have determined that lactate and/or derivatives thereof may also be orthogonal solvents, unlike the conventional organic solvents, such as cyclopentanone, GBL or PGMEA, as described above.

Namely, the inventors have determined that lactate and/or a derivative thereof may be used as solvents for solutions containing robust cross-linkable polymers dissolved and/or dispersed therein and that these solutions may be applied, for example, directly, on organic layers, such as on an OSC layer and/or on an OGI layer and/or a stack comprising one or more of these layers.

Preferably, the formulation may be applied directly on the OGI layer, which may, for example, be part of the stack. Alternatively, the formulation may be preferably applied directly on a protective layer, for example fluoropolymer protection layer, on the OSC layer. Typically, such protection layers are provided on the OSC layer for patterning, such as by dry etching as described previously.

In this way, only a single passivation layer may be required, in contrast with the conventional double passivation layer, as described above. Namely, the single passivation layer provided by the first formulation replaces the first passivation layer and the second passivation layer, as conventionally provided.

In this way, OE device fabrication complexity and/or cost may be reduced, since fewer steps and materials are required. Furthermore, since utilization of water-soluble polymers, such as PVA, is avoided, long-term stability of OE devices may be improved.

In one example, the solvent comprises lactate and/or a derivative thereof in an amount of at least 20%, at least 25%, at least 30%, at least 35%, at least 40%, at least 45%, at least 50%, at least 55%, at least 60%, at least 65%, at least 70%, at least 75%, at least 80%, at least 85%, at least 90%, at least 95%, at least 97.5%, or at least 99%, where the amount of lactate and/or a derivative thereof is a percentage by weight of total amount of solvent in the formulation.

In one example, the solvent comprises lactate and/or a derivative thereof in an amount of at most 25%, at most

30%, at most 35%, at most 40%, at most 45%, at most 50%, at most 55%, at most 60%, at most 65%, at most 70%, at most 75%, at most 80%, at most 85%, at most 90%, at most 95%, at most 97.5%, at most 99%, or at most 100%, where the amount of lactate and/or a derivative thereof is a percentage by weight of total amount of solvent in the formulation.

In one example, the solvent comprises a mixture of lactate and/or one or more derivatives thereof.

In one example, the solvent comprises a cosolvent for example, organic and/or aqueous solvents. Examples of the cosolvents may include cyclopentanone, GBL and PGMEA, propylene carbonate, diethylene glycol, isopropyl alcohol (IPA), 2-propanol and/or ethanol. In one example, the solvent comprises the cosolvent in an amount of at most 50%, at most 45%, at most 40%, at most 35%, at most 30%, at most 25%, at most 20%, at most 15%, at most 10%, at most 5%, at most 2.5%, or at most 1%, where the amount of the cosolvent is a percentage by weight of total amount of solvent in the formulation. In one example, the solvent comprises the cosolvent in an amount of at least 50%, at least 45%, at least 40%, at least 35%, at least 30%, at least 25%, at least 20%, at least 15%, at least 10%, at least 5%, at least 2.5%, or at least 1%, wherein the amount of the cosolvent is a percentage by weight of total amount of solvent in the formulation.

In one example, the solvent comprises a plurality of cosolvents. In one example, the solvent comprises the plurality of cosolvents in an amount of at most 50%, at most 45%, at most 40%, at most 35%, at most 30%, at most 25%, at most 20%, at most 15%, at most 10%, at most 5%, at most 2.5%, or at most 1%, where the amount of the plurality of cosolvents is a percentage by weight of total amount of solvent in the formulation. In one example, the solvent comprises the plurality of cosolvents in an amount of at least 50%, at least 45%, at least 40%, at least 35%, at least 30%, at least 25%, at least 20%, at least 15%, at least 10%, at least 5%, at least 2.5% or at least 1%, where the amount of the plurality of cosolvents is a percentage by weight of total amount of solvent in the formulation.

In one example, the formulation comprises the solvent in an amount of at least 20%, at least 25%, at least 30%, at least 35%, at least 40%, at least 45%, at least 50%, at least 55%, at least 60%, at least 65%, at least 70%, at least 75%, at least 80%, at least 85%, at least 90%, at least 95%, at least 97.5%, or at least 99%, where the amount of solvent is a percentage by weight of the formulation.

In one example, the formulation comprises the solvent in an amount of at most 25%, at most 30%, at most 35%, at most 40%, at most 45%, at most 50%, at most 55%, at most 60%, at most 65%, at most 70%, at most 75%, at most 80%, at most 85%, at most 90%, at most 95%, at most 97.5%, or at most 99%, where the amount of solvent is a percentage by weight of the formulation.

In one example, the formulation comprises the passivation material in an amount of at least 20%, at least 25%, at least 30%, at least 35%, at least 40%, at least 45%, at least 50%, at least 55%, at least 60%, at least 65%, at least 70%, at least 75%, at least 80%, at least 85%, at least 90%, at most 95%, at most 97.5%, or at most 99%, where the amount of passivation material is a percentage by weight of the formulation.

In one example, the formulation comprises the passivation material in an amount of at most 80%, at most 75%, at most 70%, at most 65%, at most 60%, at most 55%, at most 50%, at most 45%, at most 40%, at most 35%, at most 30%, at most 25%, at most 20%, at most 15%, at most 10%, at most 5%, at most 2.5%, or at most 1%, where the amount of the passivation material is a percentage by weight of the formulation.

***Hansen solubility parameters***

Generally, Hansen solubility parameters may be used to characterize polarity of solvents in terms of their dispersion forces $\delta_d$, the degree of polarity that arises from any dipole $\delta_p$, and their capacity for hydrogen bonding $\delta_h$. The solvents may be thus located in Hansen space with a three-dimensional (3D) representation of $\delta_d$, $\delta_p$ and $\delta_h$. The closer two solvents are in the Hansen space, the more likely they are to exhibit the same solubilising properties. The Hansen dispersion forces $\delta_d$ expressed by solvents may be similar and therefore, for a simpler representation of the Hansen solubility parameters, $\delta_p$ may be plotted against $\delta_h$ to represent different types of solvents in a two-dimensional (2D) graph.

In one example, the derivative has Hansen solubility parameters that are within 6MPa$^{1/2}$ of those for ethyl lactate. In one example, the derivative has Hansen solubility parameters that are within 3MPa$^{1/2}$ of those for ethyl lactate. In one example, the derivative has Hansen solubility parameters that are within 1.5MPa$^{1/2}$ of those for ethyl lactate.

Table 1 details Hansen solubility parameters of various solvents, including ethyl lactate and conventional solvents such as cyclopentanone, GBL and PGMEA, as described above.

Table 1: Hanson solubility parameters of ethyl lactate and conventional solvents cyclopentanone, GBL and PGMEA, as described above, were compiled from HSPiP software, Version 2 (https://www.hansen-solubility.com/).

| Solvents | $\delta_d$ Mpa$^{0.5}$ | $\delta_p$ Mpa$^{0.5}$ | $\delta_h$ Mpa$^{0.5}$ |
|---|---|---|---|
| Butyl lactate | 15.8 | 6.1 | 16.4 |

(continued)

| Solvents | $\delta_d$ Mpa$^{0.5}$ | $\delta_p$ Mpa$^{0.5}$ | $\delta_h$ Mpa$^{0.5}$ |
|---|---|---|---|
| Ethyl lactate | 16.0 | 7.6 | 12.5 |
| Methyl lactate | 17.6 | 8.59 | 12.95 |
| 2-Ethylhexyl lactate | 16.0 | 2.15 | 8.27 |
| Cyclopentanone | 17.9 | 11.9 | 5.2 |
| GBL | 18 | 16.6 | 7.4 |
| PGMEA | 15.6 | 5.9 | 9.8 |
| NMP | 18.0 | 12.3 | 7.2 |
| cyclohexanone | 17.8 | 8.4 | 5.1 |
| Dimethylformamide (DMF) | 17.4 | 13.7 | 11.3 |
| Dimethylacetamide (DMAc or DMA) | 16.8 | 11.5 | 10.2 |
| Dimethyl sulfoxide (DMSO) | 18.4 | 16.4 | 10.2 |

Ethyl lactate

While the Hansen solubility parameters may suggest that lactate and/or a derivative thereof may substitute for conventional organic solvents, such as cyclopentanone, GBL or PGMEA, in, for example, SU-8, as described above, the Hansen solubility parameters provide no indication that these conventional solvents may also be orthogonal solvents.

Surprisingly, as described above, the inventors have determined that lactate and/or a derivative thereof may also be orthogonal solvents, unlike the conventional organic solvents, such as cyclopentanone, GBL or PGMEA, as described above. Namely, lactate and/or a derivative thereof may both substitute for conventional organic solvents, such as cyclopentanone, GBL or PGMEA, in, for example, SU-8, and may be orthogonal solvents, unlike the conventional organic solvents, such as cyclopentanone, GBL or PGMEA.

Figs. 2A, 2B and 2C schematically depict 2D Hansen solubility parameter map of lactate and other commonly used solvents, some of which are used for SU8 passivation.

***Cross-linkable Composition***

In one example, the passivation material comprises a cross-linkable composition. In this way, the passivation material may be dissolved and/or dispersed in the solvent for deposition and subsequently cross-linked after deposition, with the passivation material may be resistant to organic solvents and/or aqueous solutions. Therefore, the passivation material may meet at least some of the conflicting requirements, as described above.

In one example, the passivation material comprises a cross-linkable composition in an amount of at least 50%, at least 55%, at least 60%, at least 65%, at least 70%, at least 75%, at least 80%, at least 85%, at least 90%, at least 95%, at least 97.5% or at least 99%, wherein the amount of cross-linkable composition is a percentage by weight of the passivation material.

In one example, the passivation material comprises the cross-linkable composition in an amount of at most 50%, at most 55%, at most 60%, at most 65%, at most 70%, at most 75%, at most 80%, at most 85%, at most 90%, at most 95%, at most 97.5%, at most 99% or at most 99.5%, wherein the amount of cross-linkable composition is a percentage by weight of the passivation material.

In one example, the cross-linkable composition comprises monomeric, oligomeric and/or polymeric precursors. Examples of cross-linkable compositions comprising monomeric, oligomeric and/or polymeric precursors include monomeric, oligomeric and/or polymeric precursors comprising, for example, cross-linkable epoxy groups, siloxane-organic hybrid frameworks comprising cross-linkable epoxy groups and/or cross-linkable acrylate or (alkyl)acrylate repeat units. Examples of cross-linking initiation include, for example, thermal initiation, photochemical initiation, via free radical reaction, via a thiol-ene or a thiol (alkyl)acrylate reaction, and/or via thermal azide alkyne cycloaddition reaction.

In one example, the monomeric, oligomeric and/or polymeric precursors comprise epoxy groups, which may be cross-linked.

A passivation layer may be formed by thermal or photochemical crosslinking of monomeric, oligomeric or polymeric precursors comprising epoxy groups. Typically, the passivation formulation may be coated onto a surface and then subjected to thermal or photochemical crosslinking conditions. An example of a suitable oligomeric precursor comprising epoxy groups is the commercial product EPON™ SU-8 resin (also known as EPIKOTE™ 157) available from Hexion. EPON™ resin SU-8 is a polymeric solid epoxy novolac resin, which possesses an average epoxy group functionality about 8.

Suitable monomeric, oligomeric or polymeric precursors may also comprise siloxane-organic hybrid frameworks comprising epoxy groups.

Table 2 details examples of commercially available epoxy siloxane monomeric and oligomeric precursors including products PC-1000, PC-1035, PC-2000, PC-2004, PC-2011, PC-2021 and PC-2026 available from Polyset Inc (Mechanicville, NY, USA). Other epoxy siloxane monomeric and oligomeric precursors are known.

Table 2: Epoxy siloxane monomeric and oligomeric precursors commercially available from Polyset Inc.

| **Monomer products** | **Descriptions** |
|---|---|
| PC-1000 | Bifunctional Epoxy Terminated |
| PC-1035 | Bifunctional Epoxy Terminated |
| **Oligomer products** | **Descriptions** |
| PC-2000 | Multifunctional 20,000g/mol resin |
| PC-2004 | Multifunctional 1,000 g/mol resin |
| PC-2011 | Aromatic-Epoxy Copolymer |
| PC-2021 | High EEW Copolymer |
| PC-2026 | Fluoroalkyl-Epoxy Copolymer |

An example of a crosslinked material prepared from epoxy siloxane precursors is described in J Appl Polymer Sci 2013, 39968, 1-7.

In one example, the formulation comprises at least one of a cross-linking agent, a photoacid generator, a hardener, an antioxidant, a surfactant and a filler.

The cross-linkable composition, which, for example, comprises epoxy type monomers, oligomers or polymers, may also comprise crosslinking reagent and/or catalysts. A chemical reaction used, which provides a crosslinked, insoluble layer, may be thermally or photochemically driven. An example of a thermally driven crosslinking reaction of a thin film precursor comprising a polymer substituted with epoxy groups is described in ACS Applied Materials Interfaces 2009, 1, 7, 1585. In that example, methyl tetrahydrophthalic anhydride (MeTHPA) was used as a thermal curing agent and *N*,*N*-dimethylbenzylamine (BDMA) as a catalyst to promote thermal curing.

For photochemically driven crosslinking of thin films comprising precursors, for example functionalized with epoxy groups, the passivation formulation may comprise a photoacid generator (PAG). Generally, PAGs are reagents which generate active acid catalysts on exposure to visible or ultraviolet radiation, typically ultraviolet radiation. Many different types of PAGs are known in the art. Suitable PAGs include materials in Irgacure® series, commercially available from BASF (Germany). PAG reagents may be ionic or non-ionic in nature, and within different PAGs the chemical structures may be designed to operate at different UV wavelengths. PAGs, which are commercially available, are used for operation at I-line (365nm) and g/h-line (405nm, 436nm) UV wavelengths, and are widely used in microelectronics fabrication processes.

The cross-linkable composition, which, for example, comprises epoxy type monomers, oligomers or polymers as described above, may also comprise a hardener (also known as a hardening reagent or agent) which may be used to adjust the curing time and/or the mechanical properties of the resulting crosslinked passivation layer. Examples of suitable hardeners include the ARON series of oxetane hardeners available from Toagosei (Japan).

The cross-linkable composition, for example comprising epoxy type monomers, oligomers or polymers as described above, may also comprise an antioxidant. The antioxidant may be used to suppress discoloration (yellowing) in the cross-linkable or crosslinked films, for example due to side reactions with the PAG or its chemical by-products. Examples of suitable antioxidants are described in US 2013/225711 A1.

In one example, the monomeric, oligomeric and/or polymeric precursors comprise (alkyl)acrylate repeating units, for example acrylate or methacrylate repeating units.

The crosslinkable monomer, oligomer, or polymer comprising acrylate or methacrylate repeating units, herein described collectively as (alkyl)acrylates, may be highly useful for the formation of crosslinked passivation layers. A wide

variety of (alkyl)acrylate thin film coating precursors are commercially available, for example under the SARTOMER brand produced by Arkema (France). It is known in the art that (alkyl)acrylate precursors may be selected and formulated in different proportions to provide different properties in crosslinked thin film coatings.

The (alkyl)acrylate precursor used to produce crosslinked thin film coatings, such as a passivation layer, may be monofunctional, bifunctional, or multifunctional, and may optionally be substituted with additional non(alkyl)acrylate reactive functional groups, thereby allowing further crosslinking by alternative chemical methods other than those used to polymerize the (alkyl)acrylate groups. Examples of additional non(alkyl)acrylate reactive functional groups described in WO 2013/119717 A1 are epoxy groups, or cinnamylidene groups.

The crosslinkable (alkyl)acrylate precursors suitable for use in the cross-linkable composition may themselves be oligomeric or polymeric in nature. An example of such a material is SIRIUS-501, a dendritic acrylate produced by Osaka Organic Chemical Industry Ltd (Japan).

(Alkyl)acrylate precursors suitable for use in thermally or photochemically crosslinkable films, such as passivation layers, may optionally be substituted with partially or fully fluorinated side chains. Thin films comprising polymers prepared from these precursors, and, therefore, bearing such side chain substituents, may have usefully altered properties, such as chemical resistance, hydrophobicity or surface energy.

Table 3 details a range of fluorinated (alkyl)acrylate precursors commercially available from Sigma Aldrich, a subsidiary of Merck KGaA (Germany). Other fluorinated (alkyl)acrylate precursors are known.

Table 3: Fluorinated (alkyl)acrylate precursors that are commercially available from Sigma Aldrich.

| Sigma Aldrich Products # | Structures | Descriptions | Molecular Formula |
|---|---|---|---|
| 367656 | 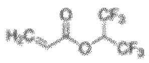 | 1,1,1,3,3,3-Hexafluoroisopropyl acrylate 99% | $C_6H_4F_6\ O_2$ |
| 367664 | 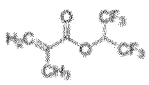 | 1,1,1,3,3,3-Hexafluoroisopropyl methacrylate 99% | $C_7H_6F_6\ O_2$ |
| 371971 | 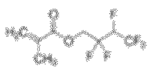 | 2,2,3,4,4,4-Hexafluorobutyl methacrylate 98% | $C_8H_8F_6\ O_2$ |
| 371998 | 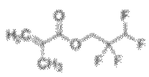 | 2,2,3,3-Tetrafluoropropyl methacrylate 99% | $C_7H_8F_4\ O_2$ |
| 373761 | 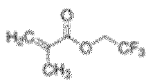 | 2,2,2-Trifluoroethyl methacrylate containing 50-200ppm MEHQ as inhibitor, 99% | $C_6H_7F_3\ O_2$ |
| 443751 | 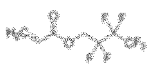 | 2,2,3,3,4,4,4-Heptafluorobutyl acrylate 97% | $C_7H_5F_7\ O_2$ |
| 444006 | 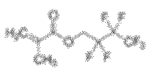 | 2,2,3,3,4,4,4-Heptafluorobutyl methacrylate 97% | $C_8H_7F_7\ O_2$ |
| 470961 | 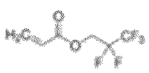 | 2,2,3,3,3-Pentafluoropropyl acrylate 98%, containing 100ppm 4-*tert*-butylcatechol as inhibitor | $C_6H_5F_5\ O_2$ |
| 470988 | 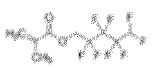 | 2,2,3,3,4,4,5,5-Octafluoropentyl methacrylate, containing 100ppm MEHQ as inhibitor, 98% | $C_9H_8F_8\ O_2$ |
| 474193 | 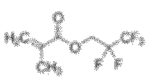 | 2,2,3,3,3-Pentafluoropropyl methacrylate 97%, containing 100ppm 4-*tert*-butylcatechol as inhibitor | $C_7H_7F_5\ O_2$ |
| 474215 | 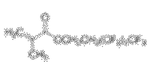 | 3,3,4,4,5,5,6,6,7,7,8,8,8-Tridecafluorooctyl methacrylate, containing 100ppm 4-*tert*-butylcatechol as inhibitor, 97% | $C_{12}H_9F_{13}\ O_2$ |

(continued)

| Sigma Aldrich Products # | Structures | Descriptions | Molecular Formula |
|---|---|---|---|
| 474223 | 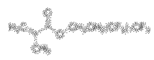 | 3,3,4,4,5,5,6,6,7,7,8,8,9,9,10,10,10-Heptadecafluorodecyl methacrylate containing MEHQ as inhibitor, 97% | $C_{14}H_9F_{17}$ $O_2$ |
| 474231 | 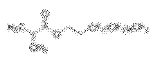 | 3,3,4,4,5,5,6,6,7,7,8,8,9,9,10,1 0,11,11,12,12,12-Heneicosafluorododecyl methacrylate 97% | $C_{16}H_9F_{21}$ $O_2$ |
| 474282 | 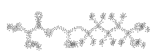 | 4,4,5,5,6,6,7,7,8,9,9,9-Dodecafluoro-2-hydroxy-8-(trifluoromethyl)nonyl methacrylate 97% | $C_{14}H_{11}F_{1\,5}$ $O_3$ |
| 474347 | 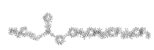 | 3,3,4,4,5,5,6,6,7,7,8,8,8-Tridecafluorooctyl acrylate containing inhibitor, 97% | $C_{11}H_7F_{13}$ $O_2$ |
| 474355 | 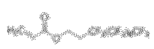 | 3,3,4,4,5,5,6,6,7,7,8,8,9,9,10,10,11,11,12,12,12-Heneicosafluorododecyl acrylate 96% | $C_{15}H_7F_{21}$ $O_2$ |
| 474401 | 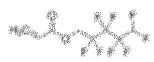 | 2,2,3,3,4,4,5,5-Octafluoropentyl acrylate 97%, containing 100ppm monomethyl ether hydroquinone as inhibitor | $C_8H_6F_8$ $O_2$ |
| 474428 | 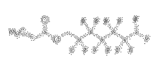 | 2,2,3,3,4,4,5,5,6,6,7,7-Dodecafluoroheptyl acrylate 95% | $C_{10}H_6F_{12}$ $O_2$ |
| 474452 | 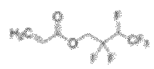 | 2,2,3,4,4,4-Hexafluorobutyl acrylate 95% | $C_7H_6F_6$ $O_2$ |
| 474487 | 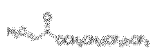 | 1H,1H,2H,2H-Perfluorodecyl acrylate containing 100ppm *tert*-butylcatechol as inhibitor, 97% | $C_{13}H_7F_{17}$ $O_2$ |
| 733660 | 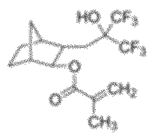 | 2-[(1',1',1'-Trifluoro-2'-(trifluoromethyl)-2'-hydroxy)propyl]-3-norbornyl methacrylate >97% | $C_{15}H_{18}F_6$ $O_3$ |
| 733695 | 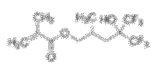 | 1,1,1-Trifluoro-2-(trifluoromethyl)-2-hydroxy-4-methyl-5-pentyl methacrylate >97% | $C_{11}H_{14}F_6$ $O_3$ |

Suitable monomeric, oligomeric or polymeric precursors may also comprise siloxane-organic hybrid frameworks comprising (alkyl)acrylate groups. An examples of such hybrid precursor is described in J Sol Gel Sci Technol 2012, 61, 2,321.

The cross-linkable composition comprising monomeric, oligomeric or polymeric (alkyl)acrylate precursors may be crosslinked using free radical reactions. The cross-linkable composition used to form crosslinkable films may additionally comprise a free radical initiator. Typically, the free radical initiator is initiated under thermal or photochemical conditions. Many examples of free radical initiators, suitable for thermal or photochemical initiation, are known in the art.

Table 4 details free radical thermal initiators commercially available from Sigma Aldrich, a subsidiary of Merck KGaA (Germany).

Table 4: Free radical thermal initiators available from Sigma Aldrich.

| Sigma Aldrich Catalogue Number | Free radical thermal initiator |
|---|---|
| 441465 | tert-Amyl peroxybenzoate |
| 118168 | 4,4-Azobis (4-cyanovaleric acid) |
| 380210 | 1,1'-Azobis (cyclohexanecarbonitrile) |
| 441090 | 2,2'-Azobisisobutyronitrile (AIBN) |
| 179981 | Benzoyl peroxide |

(continued)

| Sigma Aldrich Catalogue Number | Free radical thermal initiator |
|---|---|
| 441694 | 2,2-Bis(tert-butylperoxy)butane |
| 388149 | 1,1-Bis(tert-butylperoxy)cyclohexane |
| 388092 | 2,5-Bis(tert-butylperoxy)-2,5-dimethylhexane |
| 329533 | 2,5-Bis (tert-butylperoxy)-2,5- dimethyl-3-hexyne |
| 441716 | Bis(1-(tert-butylperoxy)-1-methyl ethyl)benzene |
| 388084 | 1,1-Bis(tert-butylperoxy)-3,3,5-trimethylcyclohexane |
| 416665 | tert-Butyl hydroperoxide |
| 388076 | tert-Butyl peracetate |
| 168521 | tert-Butyl peroxide |
| 159042 | tert-Butyl peroxybenzoate |
| 441473 | tert-Butylperoxy isopropyl carbonate |
| 247502 | Cumene hydroperoxide |
| 289086 | Cyclohexanone peroxide |
| 329541 | Dicumyl peroxide |
| 290785 | Lauroyl peroxide |
| 441821 | 2,4-Pentanedione peroxide |
| 269336 | Peracetic acid |
| 216224 | Potassium persulfate |

Table 5 details free radical photoinitiators commercially available from Sigma Aldrich, a subsidiary of Merck KGaA (Germany).

Table 5: Free radical photoinitiators available from Sigma Aldrich.

| Sigma Aldrich Catalogue Number | Free radical photoinitiator |
|---|---|
| A1,070-1 | Acetophenone, 99% |
| A8, 840-9 | Anisoin, 95% |
| A9, 000-4 | Anthraquinone, 97% |
| 12,324-2 | Anthraquinone-2-sulfonic acid, sodium salt monohydrate, 97% |
| 11,931-8 | (Benzene) tricarbonylchromium, 98% |
| B515-1 | Benzil, 98% |
| 39,939-6 | Benzoin, sublimated, 99.5+% |
| 17,200-6 | Benzoin ethyl ether, 99% |
| 19,578-2 | Benzoin isobutyl ether, tech., 90% |
| B870-3 | Benzoin methyl ether, 96% |
| B930-0 | Benzophenone, 99% |
| 40,562-0 | Benzophenone/1-Hydroxycyclohexyl phenyl ketone, 50/50 blend |
| 26,246-3 | 3,3',4,4'-Benzophenonetetracarboxylic dianhydride, sublimated, 98% |
| B1,260-1 | 4-Benzoylbiphenyl, 99% |

(continued)

| Sigma Aldrich Catalogue Number | Free radical photoinitiator |
|---|---|
| 40,564-7 | 2-Benzyl-2-(dimethyl amino)-4' -morpholinobutyrophenone, 97% |
| 16,032-6 | 4,4'-Bis(diethylamino)benzophenone, 99+% |
| 14,783-4 | 4,4'-Bis(dimethylamino)benzophenone, 98% |
| 12,489-3 | Camphorquinone, 98% |
| C7, 240-4 | 2-Chlorothioxanthen-9-one, 98% |
| 40,807-7 | (Cumene)cyclopentadienyliron (II) hexafluorophosphate, 98% |
| D3,173-7 | Dibenzosuberenone, 97% |
| 22,710-2 | 2,2-Diethoxyacetophenone, 95% |
| D11,050-7 | 4,4'-Dihydroxybenzophenone, 99% |
| 19,611-8 | 2,2-dimethoxy-2-phenylacetophenone, 99% |
| 14,934-9 | 4-(Dimethylamino)benzophenone, 98% |
| 14,670-6 | 4,4'-Dimethylbenzil, 97% |
| D14,966-7 | 2,5-Dimethylbenzophenone, tech., 95% |
| D14,967-5 | 3,4-Dimethylbenzophenone, 99% |
| 40,566-3 | Diphenyl(2,4,6-trimethylbenzoyl)phosphine oxide/2-hydroxy - 2-methylphenylacetone, 50/50 blend |
| 27,571-9 | 4'-Ethoxyacetophenone, 98% |
| E1,220-6 | 2-Ethylanthraquinone, 97+% |
| F40-8 | Ferrocene, 98% |
| 32,810-3 | 3'-Hydroxyacetophenone, 99+% |
| 27,856-4 | 4'-Hydroxyacetophenone, 99% |
| 22,043-4 | 3-Hydroxybenzophenone, 99% |
| H2,020-2 | 4-Hydroxybenzophenone, 98% |
| 40,561-2 | 1-Hydroxycyclohexyl phenyl ketone, 99% |
| 40,565-5 | 2-Hydroxy-2-methylpropiophenone, 97% |
| 15,753-8 | 2-Methylbenzophenone, 98% |
| 19,805-6 | 3-Methylbenzophenone, 99% |
| M3,050-7 | Methybenzoylformate, 98% |
| 40563-9 | 2-Methyl-4'-(methylthio)-2-morpholinopropiophenone, 98% |
| 15,650-7 | Phenanthrenequinone, 99+% |
| 29,074-2 | 4'-Phenoxyacetophenone, 98% |
| T3,400-2 | Thioxanthen-9-one, 98% |

In analogy to PAGs used for epoxy group polymerization, a variety of photochemical free radical initiators are available, allowing the operation of the photochemical crosslinking process at different wavelengths, including i line (365nm) and g/h line (405nm, 436nm).

Certain types of commercially available photochemical free radical initiators are known as Type II initiators. These photoinitiators typically require the presence of a further reagent, known as co-initiator. Commonly used examples of coinitiators for Type II systems are alcohols or amines.

In one example, the monomeric, oligomeric and/or polymeric precursors are cross-linkable via thiol-ene or thiol

(alkyl)acrylate reaction for example, as described below.

A further type of a useful chemical reaction, which is suitable for the preparation of crosslinked thin films, such as a passivation layer, is the thiol-ene reaction. The thiol-ene reaction involves the reaction of an unsaturated double bond with a separate precursor bearing a thiol (-SH) group. The unsaturated double bond may be a (alkyl)acrylate, in which case the process may be described as thiol-(alkyl)acrylate reaction. The thiol-ene or thiol-(alkyl)acrylate reaction is typically a radical reaction, which may be initiated thermally or photochemically as described above for polymerization processes using only (alkyl)acrylate precursors.

A useful property of the thiol-ene or thiol-(alkyl)acrylate reaction, as used in the preparation of crosslinked thin film coatings, such as a passivation layer, is that the reaction process is less sensitive to the inhibition from atmospheric oxygen, allowing the crosslinking process to be carried out in air rather than under an inert gas blanket.

Suitable precursors for thermal or photochemical crosslinking processes using thiol-ene or thiol-(alkyl)acrylate reactions may be monomeric, oligomeric or polymeric in nature. An example of the use of thiol-ene reaction to provide crosslinked films suitable for use as insulating layers in organic electronic devices is described in Chem Mater 2013, 25, 4806.

In one example, the monomeric, oligomeric and/or polymeric precursors are cross-linkable via a thermal azide alkyne cycloaddition reaction, for example, as described below.

An example of cross-linking via a thermal azide alkyne cycloaddition reaction is described in Shengxia Li, Wei Tang, Weimin Zhang, Xiaojun Guo and Qing Zhang, Cross-linked Polymer-Blend Gate Dielectrics through Thermal Click Chemistry, Chem. Eur. J. 2015, 21, 17762-17768 DOI: 10.1002/chem.201502825.

Another example of cross-linking via a thermal azide alkyne cycloaddition reaction is described in Sheng-Xia Li, Lin-Run Feng, Xiao-Jun Guo, Qing Zhang, *Application of thermal azide-alkyne cycloaddition (TAAC) reaction as a low temperature cross-linking method in polymer gate dielectrics for organic field effect transistors,* J. Mater. Chem. C, 2014, DOI: 10.1039/C4TC00116H.

In one example, the cross-linkable composition comprises a polyimide. Typically, polyimides are examples of oligomer precursors.

Polyimides are useful materials for the formation of protective films. The chemistry and properties of polyimides are usefully reviewed in the Handbook of Polymer Coatings for Electronics: Chemistry, Technology and Applications (2nd Edition), pages 55-65. Efforts have been made to improve the solubility and solution processability of polyimides, and solvent soluble polyimides are known in the art.

A suitable class of polyimides for use in the present application is soluble polyimide oligomers. Soluble polyimide oligomers may be further functionalized with suitable groups for thermal or photochemical crosslinking reactions, other than the backbone polyimide functional groups. The polyimide oligomers have good solvent solubility due to their low average molecular weights, and they may be conveniently coated by solution processing methods. The resultant film can then be subjected to thermal or photochemical crosslinking processes, depending on the nature of the further functionalized crosslinkable groups. This results in a highly insoluble crosslinked film. Examples of thermally crosslinked films produced from polyimide oligomers are described in EP 2524947 A1.

In one example, the cross-linkable composition comprises a cycloolefinic polymer. Typically, cycloolefinic polymers are examples of oligomeric or polymeric precursors.

A further class of material useful for passivation layers in organic electronic devices are cycloolefinic polymers. Cycloolefinic polymers bearing chemical substituents that allow further thermal or photochemical crosslinking, after deposition of the non-crosslinked film, are known in the art. Examples of suitable cycloolefinic polymers with cross-linkable side groups are described in US 9082981 and WO 2013/120581.

In one example, the cross-linkable composition comprises a substituted poly(vinylphenol) derivative, for example, as described below. For example, the poly(vinylphenol) may be substituted at the phenolic group (e.g., alkyl, aryl, aralkyl with optional further substituents). Chem Mater 2015, 25, 4806 shows one possible type of substituent (O-allyl).

Suitably substituted poly(vinylphenol) derivatives are a further class of crosslinked thin film coating precursors suitable for use in the cross-linkable composition.

Chem Mater 2015, 25, 4806 describes a composition that comprises an O-allyl derivative of poly(vinyl phenol) and pentaerythritol tetra(3-mercaptopropionate) for formation of a soluble thin film, which is then thermally crosslinked by thiol-ene reaction using AIBN as a radical initiator.

WO 2013/119717 describes derivatives of poly(vinylphenol) that may be crosslinked under photochemical conditions to provide insoluble films, such as a passivation layer.

In one example, the formulation comprises a surfactant, to improve coating properties, such as surface wettability, leveling and flow.

Formulations of the present application may optionally comprise surfactants, for example fluorinated surfactants and/or siloxane solvents, to improve coating properties, such as surface wettability, leveling and flow. An amount of a surfactant, such as fluorosurfactant, in the formulation may be in a range from 0% to 5% by weight of the formulation, preferably in a range from 0% to 2% by weight of the formulation. The amount of the surfactant may be at least 0.001%,

at least 0.01% or at least 0.1% by weight of the formulation.

An example fluorosurfactant is commercially available from AGC Seimi Chemical Co., Ltd. (Japan) as SURFLON.

Table 6 details fluorosurfactants commercially available from Cytonix LLC, Maryland (USA) as FluorN.

Table 6: Fluorosurfactants available from Cytonix.

| **FluorN** | **Chemical description** |
|---|---|
| 561 | Fluorinated Ethylene Glycol |
| 562 | Fluorinated Ethylene Glycol |
| 659 | Perfluoroalkyl Stearate |
| 1740G | Fluoro-acrylate Copolymer |
| S83 | Fluoro-acrylate Copolymer |
| 20158 | Fluoro-acrylate Copolymer |
| 2900N | PFPE polyethylene glycol |
| 1788 | PFPE-diisocyanate |

Table 7 details fluorosurfactants commercially available from DIC Corporation, Tokyo (Japan) as MEGAFACE. Preferred fluorosurfactants include MEGAFACE R-41, R-40, R-40-LM, R-43, F-556, F-557, F-554, F-559, RS-72-K, F-567, F-563, F-560, F-444, F-553, F-477, F-554, F-556, F-557, F-568, F-563 and F-560.

Table 7: Fluorosurfactants available from DIC Corporation.

| **MEGAFACE product number** | **Description** |
|---|---|
| F-114 | Perfluoro butane sulfonate |
| F-251 | Oligomer with fluoro and lipophilic groups |
| F-253 | Oligomer with fluoro and lipophilic groups |
| F-281 | Oligomer with fluoro and lipophilic groups |
| F-410 | Carboxylate with perfluoroalkyl group |
| F-430 | Oligomer with fluoro and hydrophilic groups |
| F-444 | Perfluoroalkyl ethylene oxide adduct |
| F-477 | Oligomer with fluoro, hydrophilic and lipophilic groups |
| F-510 | Phosphoric ester with fluoro group |
| F-511 | Ammonium phosphate with fluoro group |
| F-551 | Oligomer with fluoro and lipophilic groups |
| F-552 | Oligomer with fluoro and lipophilic groups |
| F-553 | Oligomer with fluoro, hydrophilic and lipophilic groups |
| F-554 | Oligomer with fluoro and lipophilic groups |
| F-555 | Oligomer with fluoro, hydrophilic and lipophilic groups |
| F-556 | Oligomer with fluoro, hydrophilic and lipophilic groups |
| F-557 | Oligomer with fluoro, hydrophilic and lipophilic groups |
| F-558 | Oligomer with fluoro and lipophilic groups |
| F-559 | Oligomer with fluoro, hydrophilic and lipophilic groups |
| F-560 | Oligomer with fluoro and lipophilic groups |
| F-561 | Oligomer with fluoro and lipophilic groups |

(continued)

| MEGAFACE product number | Description |
|---|---|
| F-562 | Oligomer with fluoro, hydrophilic and lipophilic groups |
| F-563 | Oligomer with fluoro and lipophilic groups |
| F-565 | Oligomer with fluoro, hydrophilic and lipophilic groups |
| F-568 | Oligomer with fluoro, hydrophilic and lipophilic groups |
| F-569 | Oligomer with fluoro and hydrophilic groups |
| F-570 | Oligomer with fluoro, hydrophilic, lipophilic and carboxyl groups |
| F-571 | Oligomer with fluoro, hydrophilic and lipophilic groups |
| F-572 | Oligomer with fluoro and lipophilic groups |
| R-40 | Oligomer with fluoro, hydrophilic and lipophilic groups |
| R-40-LM | Oligomer with fluoro, hydrophilic and lipophilic groups |
| R-41 | Oligomer with fluoro and lipophilic groups |
| R-43 | Oligomer with fluoro and lipophilic groups |
| R-94 | Oligomer with fluoro, hydrophilic and lipophilic groups |
| RS-55 | Oligomer with fluoro, hydrophilic, lipophilic and UV reactive groups |
| RS-56 | Oligomer with fluoro, hydrophilic, lipophilic and UV reactive groups |
| RS-72-K | Oligomer with fluoro, hydrophilic, lipophilic and UV reactive groups |
| RS-75 | Oligomer with fluoro, hydrophilic, lipophilic and UV reactive groups |
| RS-76-E | Oligomer with fluoro, hydrophilic, lipophilic and UV reactive groups |
| RS-76-NS | Oligomer with fluoro, hydrophilic, lipophilic and UV reactive groups |
| RS-78 | Oligomer with fluoro, hydrophilic, lipophilic and UV reactive groups |
| RS-90 | Oligomer with fluoro, hydrophilic, lipophilic and UV reactive groups |

Formulations of the present application may optionally comprise a siloxane solvent, particularly a cyclic siloxane solvent. The siloxane solvent may be used to alter the wettability, leveling and flow properties of the formulation. Examples of suitable siloxane solvent additives include octamethylcyclotetrasiloxane (BP 175°C), decamethylcyclopentasiloxane (BP 210°C) and dodecamethylcyclohexasiloxane (BP 245°C). The loading of siloxane solvent in the composition would be 0 to 10% by weight of the passivation material, preferably 0 to 5% by weight of the passivation material, and more preferably 0 to 2% by weight of the passivation material.

An amount of siloxane solvent in the formulation may be in a range from 0 to 10% by weight of the formulation, preferably in a range from 0 to 5% by weight of the passivation material, and more preferably in a range from 0 to 2% by weight of the passivation material. The amount of surfactant may be at least 0.001%, at least 0.01% or at least 0.1% by weight of the passivation material.

In one example, the formulation comprises a filler, to alter the physical and/or electrical properties of the crosslinked layer.

Suitable compositions for utilisation in the present application may optionally also comprise a filler. Fillers may usefully alter the physical and/or electrical properties of the crosslinked thin film coating, for example, dielectric constant, mechanical strength or dielectric breakdown strength. Suitable fillers include inorganic nanoparticles, in which case the resulting crosslinked film may be described as a polymer nanocomposite. Examples of suitable fillers are described in Materials 2009, 2, 1697-1733; doi:10.3390/ma2041697. Such described fillers include inorganic fillers, for example, $BaTiO_3$, PMN-PT (65/35), $PbNb_2O_6$, PLZT (7/60/40), $SiO_2$, $Al_2O_3$, $Ta_2O_5$, $TiO_2$, $SrTiO_3$, $ZrO_2$, $HfO_2$, $HfSiO_4$, $La_2O_3$, $Y_2O_3$, $\alpha$-$LaAlO_3$, $CaCu_3Ti_4O_{12}$ and $La_{1\cdot8}Sr_{0\cdot2}NiO_4$. These inorganic fillers may be provided as particles, for example microparticles and/or nanoparticles.

**Organic semiconductor (OSC) materials**

The organic semiconductor material (OSC) layer comprises a single component or multicomponent blend of materials, which may be evaporated or solution processed. The OSC layer is preferably solution processable and it can be polymeric, but preferably comprises a semiconducting non-polymeric polycyclic compound, such as a semiconducting non-polymeric organic polycyclic compound, which is OSC (also known as a small molecule organic semiconductor).

Preferably, the semiconducting non-polymeric polycyclic compounds have carrier mobilities of $10^{-1}$ $cm^2/Vs$ or more, more preferably 0.5 $cm^2/Vs$ or more, and even more preferably 2 $cm^2/Vs$ or more. Preferably, the semiconducting non-polymeric polycyclic compounds have carrier mobilities of less than 100 $cm^2/Vs$. The charge mobility of the semiconducting non-polymeric polycyclic compound can be determined through field effect transistor measurements on drop cast films or thermally evaporated single crystal films.

Any suitable semiconducting non-polymeric polycyclic compound may be used. These may be p-type or n-type OSC materials.

Examples of suitable semiconducting non-polymeric polycyclic compounds include polyacenes. Suitable polyacenes are disclosed in WO 2012/164282. For example, suitable polyacenes may have the structural formula shown in Formula (III) :

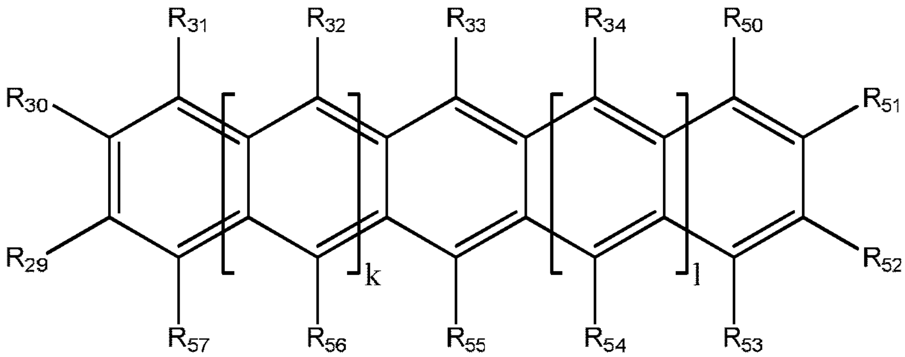

Formula (III)

wherein each of $R^{54}$, $R^{56}$, $R^{32}$ and $R^{34}$ is hydrogen; $R^{55}$ and $R^{33}$ are each $-C=C-SiR^{35}R^{36}R^{37}$, wherein $R^{35}$, $R^{36}$ and $R^{37}$ are each independently selected from $C_1$-$C_4$ alkyl, $C_2$-$C_4$ alkenyl and $C_3$-$C_6$ cycloalkyl; $R^{50}$, $R^{51}$, $R^{52}$, $R^{53}$ , $R^{57}$, $R^{29}$, $R^{30}$ and $R^{31}$ are each independently selected from hydrogen, $C_1$-$C_4$ alkyl, $C_1$-$C_6$ alkoxy and $C_6$-$C_{12}$ aryloxy; or wherein independently each pair of $R^{51}$ and $R^{52}$ and/or $R^{29}$ and $R^{30}$ may be cross-bridged to form a $C_4$-$C_{10}$ saturated or unsaturated ring, which saturated or unsaturated ring may be intervened by an oxygen atom, a sulfur atom or a group shown by formula $-N(R^{49})-$ (wherein $R^{49}$ is a hydrogen atom, a $C_1$-$C_6$ alkyl group or a $C_1$-$C_{10}$ perfluoroalkyl group; and wherein k and 1 are independently 0 or 1, preferably both k and 1 are 1, or both k and I are 0.

Suitably, in compounds of Formula (III), k and 1 are both 1; $R^{55}$ and $R^{33}$ are - $C=C-SiR^{35}R^{36}R^{37}$, wherein $R^{35}$, $R^{36}$ and $R^{37}$ are each independently selected from ethyl, n-propyl, isopropyl, 1-propenyl, 2-propenyl and $C_3$-$C_6$ cycloalkyl; and $R^{50}$, $R^{51}$, $R^{52}$, $R^{53}$, $R^{57}$, $R^{29}$, $R^{30}$ and $R^{31}$ are each independently selected from hydrogen, methyl, ethyl and methoxy.

Suitably, in compounds of Formula (III), k and 1 are both 0; $R^{55}$ and $R^{33}$ are - $C=C-SiR^{35}R^{36}R^{37}$, wherein $R^{35}$, $R^{36}$ and $R^{37}$ are each independently selected from ethyl, n-propyl, isopropyl, 1-propenyl, 2-propenyl and $C_3$-$C_6$ cycloalkyl; $R^{50}$, $R^{53}$, $R^{57}$ and $R^{31}$ are hydrogen; and $R^{51}$ and $R^{52}$ together, and $R^{29}$ and $R^{30}$ together, form 5-membered heterocyclic rings containing 1 or 2 nitrogen atoms, 1 or 2 sulfur atoms or 1 or 2 oxygen atoms, wherein the heterocyclic rings may be optionally substituted, for example by $C_1$-$C_6$ alkyl and halogen.

Especially preferred polyacene compounds are those of Formulae (IV) and (V):

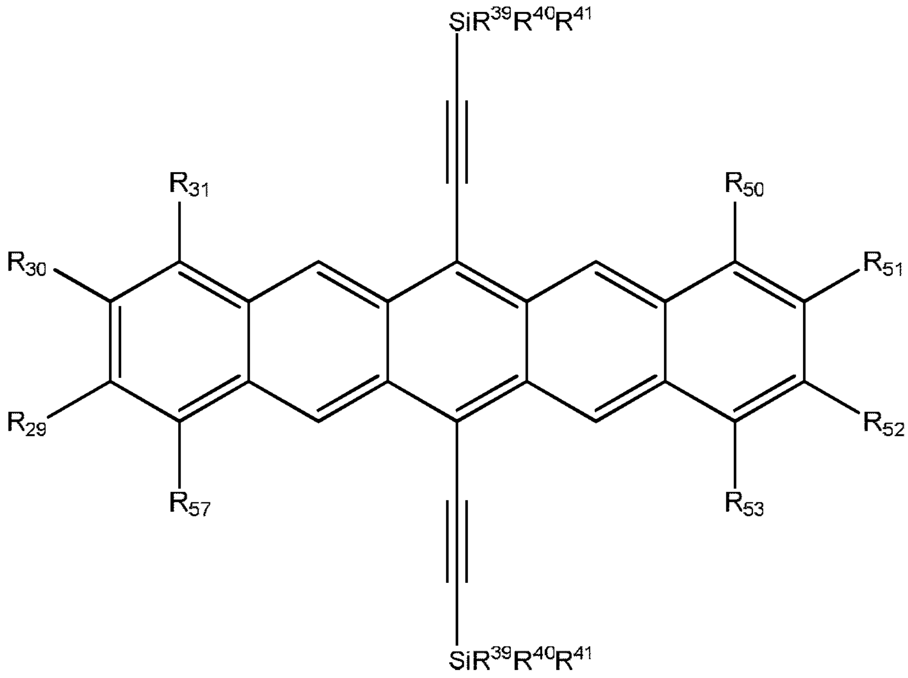

Formula (IV)

wherein $R^{50}$, $R^{53}$, $R^{57}$ and $R^{31}$ are each independently selected from hydrogen, $C_1$-$C_6$ alkyl and $C_1$-$C_6$ alkoxy (preferably $R^{50}$, $R^{53}$, $R^{57}$ and $R^{31}$ are each independently selected from hydrogen, methyl, ethyl, propyl, n-butyl, isobutyl, tert-butyl, methoxy, ethoxy, propoxy and butoxy, more preferably hydrogen, methyl, propyl and methoxy);

$R^{51}$, $R^{52}$, $R^{29}$ and $R^{30}$ are each independently selected from hydrogen, $C_1$-$C_6$ alkyl and $C_1$-$C_6$ alkoxy, or each pair of $R^{51}$ and $R^{52}$ and/or $R^{29}$ and $R^{30}$, are cross-bridged to form a $C_4$-$C_{10}$ saturated or unsaturated ring, which saturated or unsaturated ring may be intervened by an oxygen atom, a sulfur atom or a group shown by Formula -N($R^{38}$)- (wherein $R^{38}$ is hydrogen or $C_1$-$C_{10}$ alkyl); and wherein one or more of the carbon atoms of the polyacene skeleton may optionally be substituted by a heteroatom selected from N, P, As, O, S, Se and Te (preferably, $R^{51}$, $R^{52}$, $R^{29}$ and $R^{30}$ are each independently selected from hydrogen, methyl, ethyl, propyl, n-butyl, isobutyl, tert-butyl, methoxy, ethoxy, propoxy and butoxy, more preferably hydrogen, methyl, ethyl, propyl and methoxy); and $R^{39}$, $R^{40}$ and $R^{41}$ are each independently selected from $C_1$-$C_6$ alkyl and $C_2$-$C_6$ alkenyl (preferably $R^{39}$, $R^{40}$ and $R^{41}$ are each independently selected from methyl, ethyl, propyl, isopropyl, n-butyl, isobutyl, tert-butyl, 1-propenyl and 2-propenyl, more preferably ethyl, n-propyl and iso-propyl).

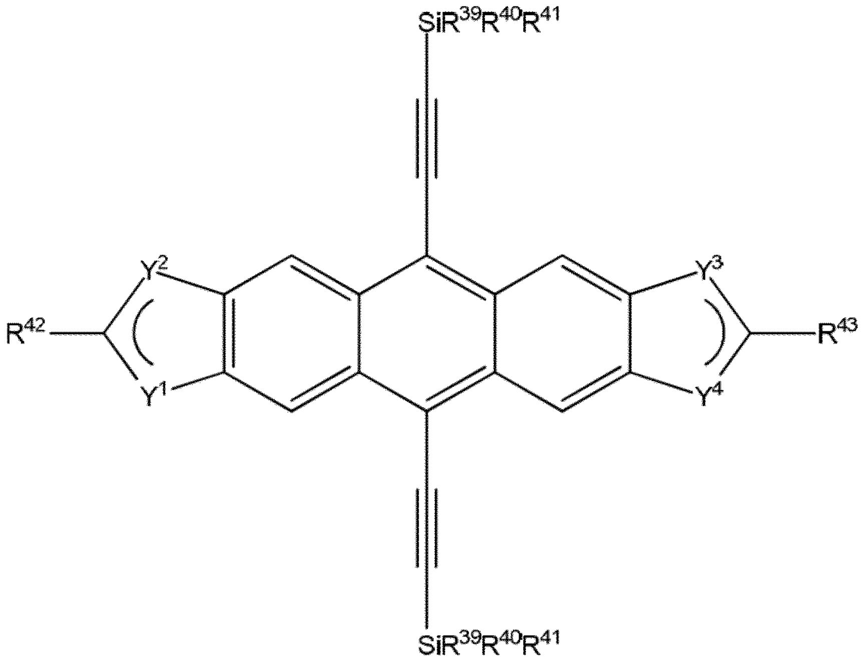

Formula (V)

wherein $R^{39}$, $R^{40}$ and $R^{41}$ are each independently selected from $C_1$-$C_6$ alkyl and $C_2$-$C_6$ alkenyl (preferably $R^{39}$, $R^{40}$ and $R^{41}$ are each independently selected from methyl, ethyl, propyl, isopropyl, n-butyl, isobutyl, tert-butyl, 1-propenyl and 2-propenyl, more preferably ethyl, n-propyl and isopropyl);

$R^{42}$ and $R^{43}$ are each independently selected from hydrogen, halogen, cyano, optionally fluorinated or perfluorinated $C_1$-$C_{20}$ alkyl, fluorinated or perfluorinated $C_1$-$C_{20}$ alkoxy, fluorinated or perfluorinated $C_6$-$C_{30}$ aryl and $CO_2R^{44}$, wherein $R^{44}$ is hydrogen, fluorinated or perfluorinated $C_1$-$C_{20}$ alkyl, or fluorinated or perfluorinated $C_6$-$C_{30}$ aryl (preferably $R^{42}$ and $R^{43}$ are each independently selected from fluorinated or perfluorinated $C_1$-$C_8$ alkyl, fluorinated or perfluorinated $C_1$-$C_8$ alkoxy and $C_6F_5$); and

$Y^1$, $Y^2$, $Y^3$ and $Y^4$ are each independently selected from -CH=, =CH-, O, S, Se or $NR^{45}$ (wherein $R^{45}$ is hydrogen or $C_1$-$C_{10}$ alkyl).

In yet another preferred embodiment, the polyacene compounds of the present application are those of Formulae (VI) and (VII):

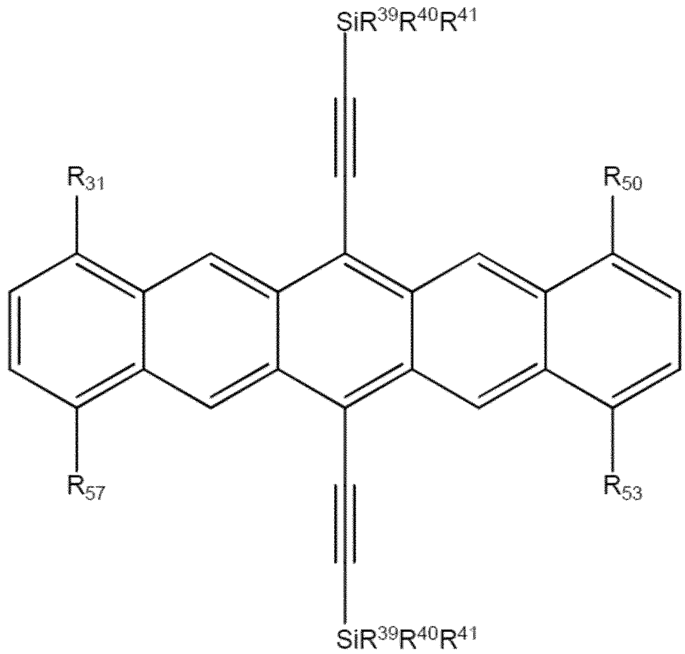

Formula (VI)

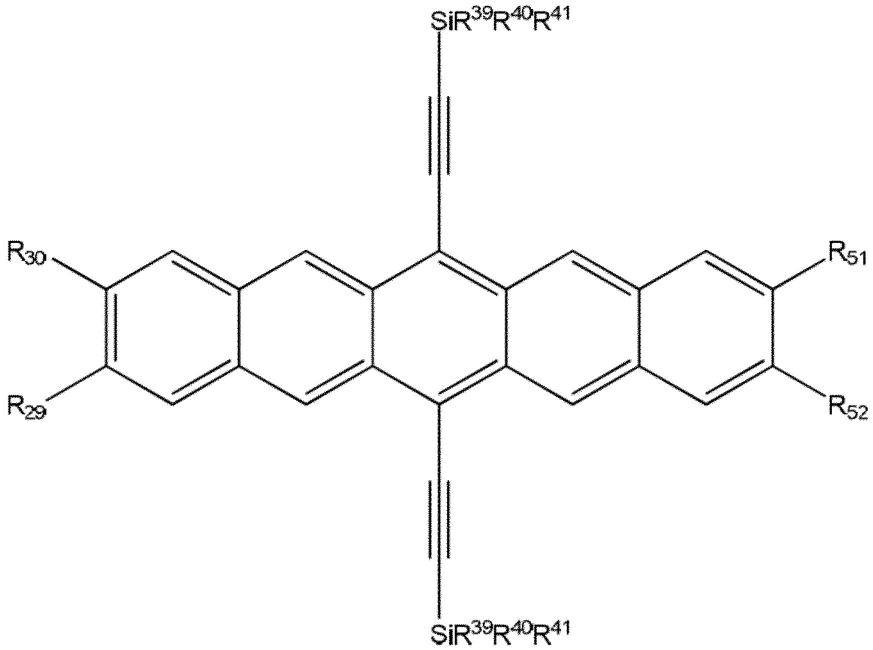

Formula (VII)

wherein $R^{39}$, $R^{40}$ and $R^{41}$ are each independently selected from methyl, ethyl and isopropyl;
wherein $R^{50}$, $R^{51}$, $R^{52}$, $R^{53}$, $R^{57}$, $R^{29}$, $R^{30}$ and $R^{31}$ are each independently selected from $C_1$-$C_6$ alkyl, $C_1$-$C_6$ alkoxy and $C_6$-$C_{20}$ aryloxy. Preferably $R^{50}$, $R^{51}$, $R^{52}$, $R^{53}$, $R^{57}$, $R^{29}$, $R^{30}$ and $R^{31}$ are each independently selected from methyl, ethyl, propyl, n-butyl, isobutyl, tert-butyl, methoxy, ethoxy, propoxy and butoxy.

Polyacene compounds may be synthesized by any known method within the common general knowledge of a person skilled in the art. In a preferred embodiment, the methods disclosed in US 2003/01 16755 A, US 3,557,233, US 6,690,029, WO 2007/078993, WO 2008/128618 and Organic Letters, 2004, Volume 6, number 10, pages 1609-1612

can be employed for the synthesis of polyacene compounds.

Preferably, the polyacene compounds have carrier mobilities of $10^{-1}$ $cm^2/Vs$ or more, more preferably of 0.5 $cm^2/Vs$ or more, and even more preferably of 2 $cm^2/Vs$ or more. Preferably, the polyacene compounds have carrier mobilities of less than 100 $cm^2/Vs$. The charge mobility of polyacene can be determined through field effect transistor measurements on drop cast films or thermally evaporated single crystal films.

For example, a suitable polyacene is 1,4,8,11-tetramethyl-6,13-bis(triethylsilylethynyl) pentacene (TMTES).

Alternative semiconductor non-polymeric polycyclic compounds used in the present application may include the following materials, either applied via solution processing or evaporation: pentacene, 2,7-dioctyl[1]benzothieno[3,2-b][1]benzothiophene (C8-BTBT), 2,9-didecyldinaphtho[2,3-b:2',3'-f]thieno[3,2-b]thiophene (C10-DNT), 3,11-didecyl-dinaphtho[2,3-d:2',3'-d']benzo[1,2-b:4,5-b']dithiophene (C10-DNBDT), 8,17-bis((triisopropylsilyl)ethynyl)tetraceno[2,1,12-qra]tetracene (Formula (VIII)), 8,17-bis((diisopropyl(octyl)silyl)ethynyl)tetraceno[2,1,12-qra]tetracene (Formula (IX)).

Formula (VIII)

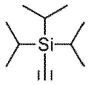

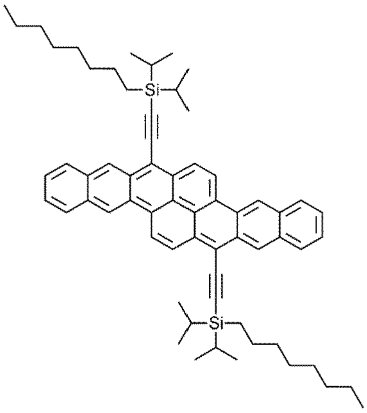

(Formula IX)

Suitable n-type small molecules could include naphthalene diimides (NTCDI) or perylene tetracarboxylic diimides (PTCDA), [6,6]-phenyl-C61-butyric acid ester ([60]PCBM) and [6,6]-phenyl-C71-butyric acid methyl ester ([70]PCBM).

The OSC layer may optionally comprise a polymeric binder material to aid film forming and uniformity. Suitable binder materials can be found in WO2012160383 which discloses high-k (permittivity > 3.4) binders in combination with small molecule semiconductors, or WO2005055248 which discloses low-k binders (1.1<k<3.3) in combination with small molecule semiconductors.

**Organic Gate Insulator (OGI) materials**

Suitable OGI materials are polymers that can be crosslinked such that they are solvent resistant or based on polymers that are not soluble in lactate and/or a derivative thereof. Examples of preferred polymers include polymers that have more than 30% of fluorine by weight and are soluble in fluorinated or perfluorinated solvents. Examples of preferred soluble amorphous fluoropolymers include Cytop (Asahi), Teflon AF (DuPont), Hyflon AD (Solvay), Fluoropel (Cytonix). Suitable solvents for the fluorinated OGI layer include Fluorinert (trade name) FC43, or Hydrofluoroethers Novec (3M) HFE7500 or HFE7700.

The OGI material may be vapor deposited through chemical vapor deposition, such as parylene, or thermal evaporation, but it is especially preferred that the OGI is deposited by solution processing.

In one example, the passivation layer provides an interlayer dielectric, arranged to isolate, for example electrically isolate, metal layers, such as a metal gate electrode from a source and/or drain electrode, on the OE device.

**Ethyl lactate**

For the avoidance of doubt, statements of the invention below explicitly recite ethyl lactate, as described above in detail. The formulation, the solvent and/or the passivation material, together with the OE device and organic layer, may be as described above with respect to the first aspect.

In one example, the solvent comprises lactate and/or a derivative thereof.

In one example, the solvent comprises lactate and/or a derivative thereof, and the passivation material comprises the cross-linkable composition.

In one example, the solvent comprises lactate and/or a derivative thereof, and the cross-linkable composition comprises monomeric, oligomeric and/or polymeric precursors.

In one example, the solvent comprises lactate and/or a derivative thereof, and the monomeric, oligomeric and/or polymeric precursors comprise an epoxy group.

In one example, the solvent comprises lactate and/or a derivative thereof, and the monomeric, oligomeric and/or polymeric precursors comprise acrylate or methacrylate repeating units.

In one example, the solvent comprises lactate and/or derivatives thereof, and the monomeric, oligomeric and/or polymeric precursors are cross-linkable via a thiol-ene or a thio (alkyl)acrylate reaction.

In one example, the solvent comprises lactate and/or a derivative thereof, and the monomeric, oligomeric and/or polymeric precursors are cross-linkable via a thermal azide alkyne cycloaddition reaction.

In one example, the solvent comprises lactate and/or a derivative thereof, and the cross-linkable composition comprises a polyimide.

In one example, the solvent comprises lactate and/or a derivative thereof, and the cross-linkable composition comprises a cycloolefinic polymer.

In one example, the solvent comprises lactate and/or a derivative thereof, and the cross-linkable composition comprises a substituted poly(vinylphenol) derivative.

In one example, the solvent comprises lactate and/or a derivative thereof, and the formulation comprises at least one of a crosslinking agent, a photoacid generator, a hardener, an antioxidant, a surfactant and a filler.

In one example, the solvent comprises lactate and/or a derivative thereof and a cosolvent.

The second aspect of the present application provides a method of fabricating an organic electronic (OE) device comprising an organic layer, wherein the organic layer is selected from an organic semiconductor (OSC) layer and an organic gate insulator (OGI) layer, wherein the method comprises:

providing a passivation layer on at least a part of the organic layer by depositing a formulation according to the first aspect and removing the solvent, for example, at least a part of the solvent, substantially all of the solvent and/or all of the solvent.

In one example, the method comprises providing a substrate. The substrate may comprise, for example, glass, metal, a polymer or an IC. The substrate may include an optional buffer layer (also known as a sublayer) provided on the surface of the substrate. The buffer layer, which may also be known as a polarization layer, is provided by a crosslinkable polymer that may improve surface uniformity and/or homogeneity by smoothing defects in the surface of the substrate and may provide a chemically inert surface upon which an OE device is fabricated. The buffer layer may comprise, for example, SU-8, crosslinked acrylate polymers or polycycloolefinic polymers. Alternatively, the substrate may comprise, for example, polyethylene terephthalate (PET) or polyethylene naphthalate (PEN), and the substrate can be processed without a buffer layer.

In one example, the method comprises providing a source and/or a drain electrode on the surface of the substrate, for example by sputtering and photolithography. The source and drain electrodes are typically metal, such as silver or gold or alloys thereof, or non-metal. The source and drain electrodes can be constructed in various potential geometries with respect to each other. One construction manner is Corbino structure, in which the source electrode surrounds the drain electrode, and the other is C-shaped or W-shaped. Alternatively, the electrodes may be linear. Examples of possible arrangements are shown in Figs. 5A to 5F. In an example, the electrodes are arranged in a non-Corbino arrangement because this is more space-saving in a small area such as a display panel pixel. Non-corbino electrodes are preferred due to the more compact arrangement of electrodes in electronic circuits, such as display panel pixels. The source and drain electrodes may be treated with a thiol solution, to adjust work functions of the source and drain electrodes. In this way, injection of charges into an overlapping OSC layer can be improved. Excess thiol solution can be washed away, with thiol being bound only to the source and drain electrodes.

In one example, the method comprises providing an OSC layer on the source and drain electrodes and the exposed surface of the substrate, for example, by spin coating or printing. The OSC layer has typically a thickness of 30 nm. In one example, the method comprises providing an OGI layer on the OSC layer, for example by spin coating or printing. The OGI layer has typically a thickness of 300 nm. A metal layer, which is, for example, silver or gold or alloys thereof, can be subsequently deposited on the OGI layer, for example, by evaporation. A photoresist can be subsequently patterned (e.g., by photolithography) on the metal layer, and portions of the metal layer exposed through

the patterned photoresist may be removed by wet etching. The patterned metal layer may provide a gate, such as a thin film transistor (TFT) gate. The geometry of the gate is defined according to the geometries of the source and drain. The width of gate size is the same as that of transistor channel, and the length of the gate is the same as that of transistor channel, with the overlap value of each end of channel counted in. The overlapping range is 0 to 50 microns, preferably 0 to 10 microns, more preferably 0 to 2 microns, and most preferably 0 to 0.5 microns. Patterned metal layers may provide a hardmask against reactive ion etching (RIE) (also known as dry etching, using, for example $O_2$ and/or Ar), thereby masking the underlying OGI layer, the OSC layer, and the source and the drain electrodes. Subsequently, RIE can remove portions of the OGI layer and the OSC layer, that are not masked by the patterned metal layer. In this way, a stack comprising the patterned metal layer, the OGI layer, the OSC layer and the source and the drain electrodes can be provided on the substrate. It should be understood that the stack generally describes a multilayered structure, and thus may comprise more or fewer and/or different layers. For example, the stack may comprise those layers at an intermediate stage of fabrication of the OE device. For example, the stack may comprise all layers of the completed OE device. Thus, layers included in the stack can change during fabrication, by addition and/or by removal of layers. Sides of the OGI layer and sides of the OSC layer may be thus exposed to, for example, RIE, and may be adversely affected by unsuitable solvents. Further, inter-layer interfaces, for example, those between the substrate and the OSC layer, between the OSC layer and the OGI layer, and/or between the OGI layer and the metal layer, may also be exposed. These inter-layer interfaces may be subject to solvent permeation, as described previously, thereby providing another vector of attack by unsuitable solvent. Other surfaces of the OGI layer and/or the OSC layer may be additionally and/or alternatively exposed.

In one example, the method comprises providing the passivation layer on the stack and the exposed surface of the substrate, for example, by coating with a formulation according to an exemplary embodiment of the present application.

In one example, the method comprises providing a positive photoresist mask on the passivation layer.

In one example, the method comprises forming a first hole or via through the passivation layer to reach the patterned metal layer, by RIE through the positive photoresist mask, thereby exposing at least a part of the surface of the metal layer.

In one example, the method comprises removing residual photoresist mask.

In one example, the method comprises providing a metal gate interconnect through the first hole to reach the patterned metal layer, for example, by sputtering, masking and etching.

The third aspect of the present application provides an organic electronic (OE) device comprising an organic layer and a passivation layer directly thereon, wherein the organic layer is selected from an organic semiconductor (OSC) layer and an organic gate insulator (OGI) layer, and wherein the passivation layer comprises a cross-linked product of a cross-linkable composition according to the first aspect.

In one example, the OE device is selected from a group consisting of an Organic Field Effect Transistor (OFET) such as a bottom gate OFET or preferably a top gate OFET, including Organic Thin Film Transistor (OTFT), an Organic Light Emitting Diode (OLED), an Organic Photovoltaic (OPV) device and an Organic Photodetector (OPD).

In one example, the organic field effect transistor (OFET) device, preferably, one of the source or drain electrodes does not completely surround the other, and more preferably, the overlap between the gate metal and the source and drain electrodes is less than 5 microns.

The fourth aspect of the present application provides a product comprising an organic electronic (OE) device fabricated according to the second aspect and/or an OE device according to the third aspect.

In one example, the product is selected from a group consisting of an Integrated Circuit (IC), a Radio Frequency Identification (RFID) tag, a security marking or security device containing an RFID tag, a Flat Panel Display (FPD), a backplane of an FPD, a backlight of an FPD, an electrophotographic device, an electrophotographic recording device, an organic storage device, a sensor, a biosensor and a biochip.

The fifth aspect of the present application provides a flowable formulation comprising a photopatterning material and a solvent; wherein the solvent comprises lactate and/or a derivative thereof.

The solvent may be as described with respect to the first aspect. The photopatterning material may be similar to the passivation material described with respect to the first aspect.

The sixth aspect of the present application provides use of a solvent comprising lactate and/or a derivative thereof in a method of fabricating an organic electronic (OE) device comprising an organic layer, wherein the organic layer is selected from an organic semiconductor (OSC) layer and an organic gate insulator (OGI) layer.

The solvent may be as described with respect to the first aspect. The method of fabricating may be as described with respect to the second aspect.

Figs. 3A and 3B show schematically a method of fabrication of an OE device, specifically, a top gate OFET, according to an embodiment of various aspects of the present application. Typically, such a method of fabrication may be achieved practically by photolithographic processing, as known to the person skilled in the art.

In contrast to the method of fabrication described above with reference to Figs. 1A and 1B, a formulation

according to an exemplary embodiment of the present application is used, thereby eliminating at least one step of the prior art method. In this way, OE device fabrication complexity and/or cost can be reduced. Furthermore, water-soluble polymers, such as PVA, which may be hygroscopic, are avoided, thereby improving long-term stability of OE devices fabricated according to exemplary embodiments of the present application. In addition, the formulation used comprises a "green" solvent, thereby improving the environmental profile of the formulation.

At S301, as described previously with reference to S101, a substrate 310 is provided. The substrate 310 may comprise, for example, glass, metal, a polymer or an IC. The substrate 310 may comprise an optional buffer layer (also known as a sublayer) provided on the surface of the substrate 310. The buffer layer, which may also be known as a planarization layer, is provided by a crosslinkable polymer that may improve surface uniformity and/or homogeneity by smoothing defects in the surface of the substrate and may provide a chemically inert surface upon which the OE device is fabricated. The buffer layer may comprise, for example, crosslinked acrylate polymers or polycycloolefinic polymers. Alternatively, the substrate 310 may comprise polyethylene terephthalate (PET) or polyethylene naphthalate (PEN), for example, and may be processed without a buffer layer.

At S302, as described previously with reference to S102, source and drain electrodes 320 are provided on the surface of the substrate 310, for example, by sputtering and photolithography (using mask 1). The source and the drain electrodes 320 are typically metal, such as silver or gold or alloys thereof, or non-metal. The source and the drain electrodes 320 may be treated with a thiol solution, to adjust work functions of the source and drain electrodes 320. In this way, injection of charges into an overlapping OSC layer can be improved. Excess thiol solution can be washed away, with thiol being bound only to the source and drain electrodes 320.

At S303, as described previously with reference to S103, firstly, an OSC layer 330 is provided on the source and drain electrodes 320 and the exposed surface of the substrate 310, for example, by spin coating or printing. The OSC layer 330 has typically a thickness of 30 nm. An OGI layer 340 is subsequently provided on the OSC layer 330, for example, by spin coating or printing. The OGI layer 340 has typically a thickness of 300 nm. A metal layer 350, which is, for example, silver or gold or alloys thereof, is subsequently deposited on the OGI layer 340, for example, by evaporation. A photoresist (not shown) is subsequently patterned (e.g., by photolithography) on the metal layer 350, and portions of the metal layer 350 exposed through the patterned photoresist are removed by wet etching. The patterned metal layer 350 provides a gate, such as a thin film transistor (TFT) gate. The patterned metal layer 350 also provides a hardmask (mask 2) against reactive ion etching (RIE) (also known as dry etching, using, for example $O_2$ and/or Ar), thereby masking the underlying OGI layer 340, the OSC layer 330 and the source and the drain electrodes 320. Subsequently, RIE removes portions of the OGI layer 340 and the OSC layer 330 that are not masked by the patterned metal layer 350. In this way, a stack 300 comprising the patterned metal layer 350, the OGI layer 340, the OSC layer 330 and the source and the drain electrodes 320 is provided on the substrate 310. It should be understood that the stack 300 generally describes a multilayered structure, and thus may comprise more or fewer and/or different layers. For example, the stack 300 may comprise those layers at an intermediate stage of fabrication of the OE device. For example, the stack 300 may comprise all the layers of the completed OE device. Thus, layers included in the stack 300 may change during fabrication, by addition and/or by removal of layers. Sides 341 of the OGI layer 340 and sides 331 of the OSC layer 330 may be thus exposed to, for example, RIE, and may be adversely affected by unsuitable solvents. Further, inter-layer interfaces, for example, those between the substrate 310 and the OSC layer 330, between the OSC layer 330 and the OGI layer 340, and/or between the OGI layer 340 and the metal layer 150, may also be exposed. These inter-layer interfaces may be subject to solvent permeation, as described previously, thereby providing another vector of attack by unsuitable solvents. Other surfaces of the OGI layer 340 and/or the OSC layer 330 may be additionally and/or alternatively exposed.

At S304, in contrast to as described previously with reference to S104, a passivation layer 360 is provided on the stack 300 and the exposed surface of the substrate 310, for example, by coating with a formulation according to an exemplary embodiment of the present application.

Specifically, the formulation comprises a passivation material and a solvent, wherein the solvent comprises lactate and/or a derivative thereof. In this example, the passivation material comprises a cross-linkable composition, such as bisphenol A novolac epoxy, and the solvent comprises ethyl lactate. In this example, the passivation material is dissolved in the solvent.

In contrast the conventional method of fabrication described above with reference to Figs. 1A and 1B, in which the first passivation layer 180 and the second passivation layer 190 are required for reasons as described above, only the single passivation layer 360 is required, according to an exemplary embodiment of the present application. The single passivation layer 360 provides the robustness required to ensure environmental, chemical and/or physical protection of the fabricated OE device, similar to the second passivation layer 190 described above, that required also the first passivation layer 180. In this way, OE device fabrication complexity and/or cost can be reduced. Furthermore, water-soluble polymers, such as PVA, which may be hygroscopic, are avoided, thereby improving long-term stability of OE devices fabricated according to exemplary embodiments of the present application.

In this example, the passivation material is crosslinked by UV. The passivation layer 360 has typically a thickness

of between 300 nm and 2000 nm.

At S305, a positive photoresist mask 361 (mask 3) is provided on the passivation layer 360, similarly to as described previously at S105 with reference to Figs. 1A and 1B.

At S306, a first hole or via is formed through the passivation layer 360 toreach the patterned metal layer 350, by RIE through the positive photoresist mask 361, thereby exposing at least a part of the surface of the metal layer 350, similarly to as described previously at S106 with reference to Figs. 1A and 1B.

At S307, residual photoresist mask 381 is removed, similarly to as described previously at S107 with reference to Figs. 1A and 1B.

Since only the single passivation layer 360 may be required, provision of a second passivation layer, such as described previously at S108 with reference to Figs. 1A and 1B, is not required. In this way, OE device fabrication complexity and/or cost can be reduced. Furthermore, water-soluble polymers, such as PVA, which may be hygroscopic, are avoided, thereby improving long-term stability of the OE device fabricated according to exemplary embodiments of the present application. In addition, the formulation used comprises a "green" solvent, thereby improving the environmental profile of the formulation.

At S309, a metal gate interconnect 370 is provided through the first hole to reach the patterned metal layer 350, for example, by sputtering, masking (mask 4) and etching, similarly to as described previously at S107 with reference to Figs. 1A and 1B.

In this way, the OE device having a single passivation layer 360 may be provided.

Therefore, in contrast with the conventional process described with reference to Figs. 1A and 1B, only the single passivation layer 360 may be required. Furthermore, water-soluble polymers are avoided. In addition, the formulation used comprises a "green" solvent. In addition, according to this method of fabrication of OE device, only four masks (mask 1 to mask 4) are required, unlike the conventional process which requires five masks.

Fig. 4 shows schematically a method of fabrication of another OE device, according to an embodiment of aspects of the present application. Typically, such a method of fabrication may be achieved practically by photolithographic processing, as known to the person skilled in the art.

In contrast to the method of fabrication described above with reference to Figs. 1A and 1B, a formulation according to an exemplary embodiment of the present application is used, thereby eliminating at least one step of the prior art method. In this way, OE device fabrication complexity and/or cost can be reduced. Furthermore, water-soluble polymers, such as PVA, which may be hygroscopic, are avoided, thereby improving long-term stability of the OE device fabricated according to exemplary embodiments of the present application.

At S401, as described previously with reference to S101, a substrate 410 is provided. The substrate 410 may comprise, for example, glass, metal, a polymer or an IC. The substrate 410 may include an optional buffer layer provided on the surface of the substrate 410. The buffer layer, which can also be known as a planarization layer, is provided by a cross-linkable polymer that may improve surface uniformity and/or homogeneity by smoothing defects in the surface of the substrate and may provide a chemically inert surface upon which the OE device is fabricated.

At S402, as described previously with reference to S103, firstly, an OSC layer 430 is provided on the exposed surface of the substrate 410, for example, by spin coating or printing. The OSC layer 430 has typically a thickness of 30 nm.

At S403, an OGI layer 440 is subsequently provided on the OSC layer 430, for example, by spin coating or printing. The OGI layer 440 has typically a thickness of 300 nm. In this way, a stack 400 comprising the OGI layer 440 and the OSC layer 430 is provided on the substrate 410. It should be understood that the stack 400 generally describes a multilayered structure, and thus may comprise more or fewer and/or different layers. For example, the stack 400 may comprise those layers at an intermediate stage of fabrication of the OE device. For example, the stack 400 may comprise all layers of the completed OE device. Thus, layers included in the stack 400 may change during fabrication, by addition and/or by removal of layers. Sides 441 of the OGI layer 440 and sides 431 of the OSC layer 430 may be thus exposed to, for example, RIE, and may be adversely affected by unsuitable solvents. Further, inter-layer interfaces, for example those between the substrate 410 and the OSC layer 430 and/or between the OSC layer 430 and the OGI layer 440, may also be exposed. These inter-layer interfaces may be subject to solvent permeation, as described previously, thereby providing another vector of attack by unsuitable solvents. Other surfaces of the OGI layer 440 and/or the OSC layer 430 may be additionally and/or alternatively exposed.

At S404, a passivation layer 460 is provided on the stack 400 and the exposed surface of the substrate 410, for example, by coating with a formulation according to an exemplary embodiment of the present application.

The passivation layer 460 may be provided as described previously with reference to S304.

Specifically, the formulation comprises a passivation material and a solvent, wherein the solvent comprises lactate and/or a derivative thereof.

In contrast the conventional method of fabrication described above with reference to Figs. 1A and 1B, in which the first passivation layer 180 and the second passivation layer 190 are required for reasons as described above, only the single passivation layer 460 is required, according to an exemplary embodiment of the present application. The single passivation layer 460 provides the robustness required to ensure environmental, chemical and/or physical protection of the fabricated OE device, similar to the second passivation layer 190 described above, that required also the first passivation layer 180. In this way, OE device fabrication complexity and/or cost can be reduced. Furthermore, water-soluble polymers, such as PVA, which may be hygroscopic, are avoided, thereby improving long-term stability of OE devices fabricated according to exemplary embodiments of the present application.

Since only the single passivation layer 460 may be required, provision of a second passivation layer, such as described previously at S108 with reference to Figs. 1A and 1B, is not required. In this way, OE device fabrication complexity and/or cost can be reduced. Furthermore, water-soluble polymers, such as PVA, which may be hygroscopic, are avoided, thereby improving long-term stability of the OE device fabricated according to exemplary embodiments of the present application.

In this way, the OE device having a single passivation layer 460 can be provided.

Figs. 5A to 5F show a series of different structures of source and drain electrodes of an organic thin film transistor (OTFT). Fig. 5A shows the design of a Corbino structure, in which the drain electrode 502 is surrounded by the source electrode 501 with the OTFT channel 503 therebetween. After the organic dielectric layer (OGI)and the organic semiconductor layer (OSC) are dry etched, this special OTFT design does not expose a part of the channel to the passivation layer solvent, and thus is less sensitive to the type of the passivation layer solvent. However, the overall size of the smallest OTFT that can be achieved is limited due to the need to form a via down to the drain electrode. Figs. 5B to 5F are all designs of linear OTFTs having the source electrode 501, the drain electrode 502 and the channel 503. In Fig. 5F, a gate metal 504 is shown. It can be seen that when the organic dielectric layer (OGI) and the organic semiconductor layer (OSC) are patterned using the gate metal, there is a region at the end of each OTFT channel finger pattern in an interdigital device that will be in direct contact with the passivation layer solvent. This region, which is marked as 505, is one of OTFT channel finger patterns. In this particular design, there are a total of 12 regions marking the finger ends of OTFT channels.

## *Example 1*

Example 1 relates to fabrication of an OTFT device, including a passivation formulation of SU-8 polymer in ethyl lactate solvent.

10cm x 10cm glass substrate (Corning Eagle XG) was treated using ultrasound for 20 minutes in Deconex (3% w/w in water) followed by rinsing in ultrapure water, and dried using compressed air. The substrate was baked at 70°C for 30 minutes in a convection furnace. The substrate was then spin-coated with a thermally cross-linkable polymer (P11) (available to the public from NeuDrive Ltd) as a buffer layer (also known as a sublayer). After spin coating, the substrate was first placed on a hotplate at 95°C for 2 minutes to softbake, and then baked at 150°C for 60 minutes. The final thickness of P11 layer was measured to be 1 micron.

After the preparation of the P11 sublayer, the substrate was sputter coated with 50nm of Au, and then source and drain electrodes were prepared with a combination of photolithographic and wet etching techniques (etchant composition: potassium iodide and iodine in water). A linear interdigital design was applied to source and drain electrodes, and had different transistor channel widths and lengths. After removal of the residual photoresist from the source and drain contacts by UV flash exposure and spin-coating development, the substrates were inspected under an optical microscope, and channel length features were measured in several areas of the substrate.

Before proceeding with the organic thin-film transistor (OTFT) fabrication, the substrate was treated in a Plasma Etch Inc. PE100 surface treatment system, using $Ar/O_2$ plasma. Each gas was supplied at a concentration of 50 sccm and a RF power of 250 W for 65 s.

Prior to spin coating of the organic semiconductor (OSC), a 10 mM solution of 3-fluoro-4-methoxythiophenol in 2-propanol was applied to the surface of the electrodes for 1 minute followed by rinsing in 2-propanol (2 times), followed by drying on a hotplate at 100°C for 1 minute. An OSC formulation of 1,4,8,11-tetramethyl bis-triethylsilylethynyl pentacene (TM-TES) and 30:70 4-isopropylcyano-polytriarylamine (PTAA): 2,4-dimethyl polytriarylamine copolymer (binder) was formulated at ratio of 1 part of TM-TES to 2 parts of binder by weight in 1,2,3,4 tetrahydronaphthalene in a mixed solvent system, composed of 1,2,3,4-tetrahydronaphthalene and isopropanol at a ratio of 9:1 (by weight), as for example, described in Example 5 in WO 2012/160383. The OSC formulation was then coated by spin coating at 1250 rpm for 60 seconds onto the SD electrodes using a Suss RC12 spinner set at 1250 rpm for 1 minute, followed by baking on a hotplate for 60 seconds at 100°C. For the organic dielectric layer (OGI), a solution of 1 part Cytop 809M(Asahi Glass) and 2 parts FC43 solvent (Acros Organics) was spin-coated at 1500rpm for 20 seconds , and the sample was baked on a hotplate for 60 seconds at 100°C. The thickness of the organic dielectric layer (OGI) was 160 nm.

The substrates were then coated with 50 nm of Au by thermal evaporation, and the gate electrodes were patterned by a combination of photolithography and wet etching as described above. Thereafter, the photoresist on the Au was removed by UV flash exposure and development.

**Dry etching to pattern the OSC layer**

An example passivation layer formulation was here provided containing 2.5g of EPON-SU-8 base polymer (i.e., a passivation material comprising a cross-linkable composition, wherein the cross-linkable composition comprises polymeric precursors comprising epoxy groups) and 17g of ethyl lactate. The passivation layer further contains 0.5g of triarylsulfonium hexafluoroantimonate solution (50% solution by weight in propylene carbonate) as a cross-linking agent. That is, the solvent of this passivation formulation comprises 17g of ethyl lactate together with 0.25g of propylene carbonate as a cosolvent.

The formulation of SU-8 and photoinitiator in ethyl lactate was spin-coated at 500rpm for 10 seconds followed by 1250rpm for 30 seconds, and then baked on a hotplate at 95°C for 2 minutes to form a dry film. The sample was inspected under the microscope to ensure that the solvent of passivation layer does not affect OSC/OGI/gate layers. The film layer was exposed to UV (broadband g, h, I lines, exposure amount of 1000mJ) with a Tamarack mask alignment exposure machine to expose the film to UV light. It was then baked at 115°C for 5 minutes. 1.8 micron Shipley S1805 photoresist was spin coated on the surface and baked at 115°C for 1 minute. The via mask (VIA MASK, which is a dark field mask) was aligned with the first metal layer (using EVG6200 mask alignment exposure machine) to ensure that the via is patterned on the underlying metal pattern, with an exposure amount of 84mJ. After exposure, the photoresist development was performed and the feature pattern was inspected. The via shape in the photoresist was transferred to SU8 film by reactive ion etching (RIE) using Aurion RIE system. The dry etching process was performed at a pressure of 0.07hPa, a power of 730W, a process time of 260s, a $O_2$ flow rate of 100 sccm, a Ar flow rate of 40 sccm, and a $CF_4$ flow rate of 10 sccm. After the via was inspected under an optical microscope, the residual photoresist was removed by flood exposure and development.

Then, 50 nm of Au was deposited onto the above surface by metal sputtering, and the metal layer was patterned by photolithography and wet etching to form the top metal pattern of the via structure.

Comparative Example - Passivation Layer using SU8 in Cyrene Solvent

A SU8 formulation was prepared comprising 2.5g EPON-SU-8 base polymer (i.e., passivation material comprising a cross-linkable composition, wherein the cross-linkable composition comprises polymeric precursors comprising epoxy groups) and 15.3g Cyrene and 1.7g hexanol. The passivation formulation further comprised 0.5g triarylsulfonium hexafluoroantimonate solution (50% solution by weight in propylene carbonate) as a crosslinking agent.

**OTFT Characterization**

OTFTs were tested using a Wentworth Pegasus 300S semi-automatic probe station in conjunction with a Keithley S4200 semiconductor parameter analyzer. This allowed a statistically significant number of OTFT device measurements to be made on each substrate. The Keithley system calculated the linear mobility according to the equation shown below:

$$\mu = \frac{\partial I_{DS}}{\partial V_{GS}} \frac{L}{W C_i V_{DS}}$$

wherein L is the transistor length, W is the transistor width, $I_{DS}$ is the drain to source current, and $C_i$ is the dielectric capacitance per unit area. $V_{DS}$ (drain-source voltage) was set at -2V, and $V_{GS}$ (gate voltage) was varied from depletion to accumulation (+20V to -29V in 1V steps). The mobility values reported are an average of the 5 highest points in accumulation for each transistor. The data is reported for the channel lengths shown below and is displayed as an average of the devices measured. To exclude devices with gate leakage, a ratio of the gate current to the source-drain current was set at the highest $V_{GS}$ value for a $V_{DS}$ of - 2V. If this ratio was below 10 (i.e. the gate current was more than 10% of the source-drain current), then the device was excluded from the results. The standard deviation of the mobility values is reported as a percentage of the mean. Turn on voltage of the transistor ($V_{to}$) is defined as the gate voltage point at which the derivative of the logarithm of the drain current with respect to gate voltage is a maximum. It represents the transition point where the device starts to switch from the off state towards the on state. On/off ratio is defined as the maximum current in accumulation (at $V_g$=-29V) divided by the off current in depletion. The subthreshold swing S is defined as the numerical value of the gate voltage required to change the drain current by one order of magnitude.

**Results**

The electrical test results of OTFT prepared using ethyl lactate as the solvent of SU8 passivation layer are shown in the table below. Four groups of transistors of the same design were fabricated on a 4" square substrate and tested. The transistors use a linear cross channel design.

| Channel length [microns ] | Channel width [microns ] | Average mobility [$cm^2/Vs$ ] | Mobility standard deviatio n % | Current on/off ratio $I_{on/off}$ (average ) | Counted number of devices |
|---|---|---|---|---|---|
| 12 | 9800 | 4.09 | 12.4% | 7.49E+0 7 | 12 |
| 12 | 9800 | 3.96 | 10.9% | 6.85E+0 7 | 11 |
| 12 | 9800 | 4.15 | 9.2% | 6.33E+0 7 | 11 |
| 12 | 9800 | 4.15 | 6.2% | 6.89E+0 7 | 11 |

The results show that high performance linear source-drain OTFT with low turn-on voltage can be prepared by using ethyl lactate as the solvent of SU8 passivation layer. Figs. 6A and 6B show the transfer characteristics and mobility curves of the fourth group of devices from the substrate, respectively (the results of 11 devices are plotted on each graph).

***Example 2***

Further device test results were obtained using a series of transistor designs with different channel widths, where ethyl lactate was used as the solvent of SU8 passivation layer. In this group of devices, the thickness of the organic dielectric layer (OGI) was 300 nm, and the etching time for the organic dielectric layer (OGI) and the organic semiconductor layer (OSC) was 60 s.

The results are shown in the table below, and the transfer characteristics and mobility curves are also shown in Figs. 6C and 6D, respectively.

| Channel lengths [micron] | Channel widths [micron] | Average mobility [$cm^2/Vs$] | Mobility standard deviation % | Current on/off ratio $I_{on/off}$ (average) | Counted number of devices |
|---|---|---|---|---|---|
| 12 | 200 | 3.64 | 11.5% | 5.57E+06 | 10 |
| 12 | 816 | 3.66 | 9.0% | 1.94E+07 | 7 |
| 12 | 2000 | 3.61 | 9.6% | 3.53E+07 | 10 |
| 12 | 280 | 3.37 | 16.0% | 6.53E+06 | 10 |

***Example 3 (Comparative Experiment)***

The comparative data of the device using the passivation layer coated with the passivation layer formulation containing a solvent mixture of Cyrene and hexanol (9: 1 by weight) was obtained, with the same solid content and crosslinking formulation as those in Example 2 being used. Although the mobility shown in the table below is generally comparable to the results in Example 2, the transfer characteristic curve in Figure 7A shows the significantly reduced performance thereof - subthreshold slope and low current on/off ratio.

| Channel lengths [micron] | Channel widths [micron] | Average mobility [$cm^2/Vs$] | Mobility standard deviation % | Current on/off ratio $I_{on/off}$ (average) | Counted number of devices |
|---|---|---|---|---|---|
| 12 | 200 | 2.89 | 7.4% | 1.61E+04 | 16 |
| 12 | 816 | 3.00 | 17.8% | 3.34E+04 | 16 |
| 12 | 2000 | 2.81 | 22.5% | 7.64E+04 | 15 |
| 12 | 280 | 2.72 | 26.9% | 8.97E+03 | 15 |

In summary, the present application provides a formulation for preparing a passivation and/or photo-patterning layers for use in fabrication of organic electronic devices that may be provided, for example directly, on organic layers, such as an organic dielectric layer (OGI) and an organic semiconductor layer (OSC) and/or a stack comprising one or more of these layers, without adversely affecting the organic layers. The formulation comprises a solvent of lactate and/or a derivative thereof. Further, the present application provides a method of fabrication of organic electronic devices, using such a formulation, which can reduce the complexity and cost of the device. In addition, the present application provides an organic electronic device, including a passivation layer and/or a photopatterning layer provided by such a formulation, that has better long-term stability.

Although preferred embodiments have been shown and described, it will be appreciated by those skilled in the art that various changes and modifications might be made without departing from the scope of the application, as defined in the appended claims. For example, the square pad and frame corresponding with the square aperture may be modified to be a circular pad and frame to correspond with a circular aperture. For example, the gap may be provided within the aperture rather than outside and adjacent to the aperture.

Attention is directed to all papers and documents which are filed concurrently with or previous to this specification in connection with this application and which are open to public inspection with this specification, and the contents of all such papers and documents are incorporated herein by reference.

All features disclosed in this specification (including any accompanying claims and drawings), and/or all of the steps of any method or process so disclosed, may be combined in any combination, except combinations where at least some of such features and/or steps are mutually exclusive.

Each feature disclosed in this specification (including any accompanying claims and drawings) may be replaced by alternative features serving the same, equivalent or similar purpose, unless expressly stated otherwise. Thus, each feature disclosed is one example only of a generic series of equivalent or similar features, unless explicitly stated otherwise.

The present application is not restricted to the details of the foregoing embodiment(s). The present application extends to any novel one or any new combination, of the features disclosed in this specification (including any accompanying claims and drawing), or to any new one, or any new combination, of the steps of any method or process so disclosed.

This disclosure is an example of the principles of the embodiments of the present application and is not intended to limit the application in any form or substance, or to limit the application to specific embodiments. It will be apparent to those skilled in the art that the elements, methods and systems, etc. of the technical schemes of the embodiments of the present application may be altered, changed, modified and evolved without departing from the principles, spirit and scope as defined in the claims of the embodiments and technical schemes of the present application as described above. These altered, changed, modified and evolved embodiments are all included in the scope of equivalent embodiments of the present application, which are all included within the scope of the present application defined by the claims. Although embodiment of the present application may be embodied in many different forms, some embodiments of the present application are described in detail herein. In addition, any possible combination of some or all of the various embodiments described herein is included in the embodiments of the present application and is also included in the scope of the present application defined by the claims. All patents, patent applications and other cited materials mentioned anywhere in the present application or any of the cited patents, cited patent applications or other cited materials are hereby incorporated by reference in their entirety.

The above disclosure is provided as illustrative rather than exhaustive. For those skilled in the art, this specification will suggest many variations and alternatives. All such alternatives and variations are intended to be included within the scope of the claims, wherein the term "including" means "including, but not limited to".

The description of the alternative embodiments of the present application is completed herein. Those skilled in the art will recognize other equivalent variations of the embodiments described herein, which are also encompassed by the claims appended hereto.

## Claims

1. A flowable formulation for depositing a passivation layer on an organic electronic (OE) device comprising an organic layer, wherein the organic layer is selected from an organic semiconductor (OSC) layer and an organic gate insulator (OGI) layer, wherein the formulation comprises a passivation material and a solvent;
   wherein the solvent comprises lactate and/or a derivative thereof.

2. The formulation according to claim 1, wherein the derivative has Hansen solubility parameters that are within $6MPa^{1/2}$ of those for ethyl lactate.

3. The formulation according to claim 1, wherein the passivation material comprises a cross-linkable composition.

4. The formulation according to claim 3, wherein the cross-linkable composition comprises monomeric, oligomeric and/or polymeric precursors.

5. The formulation according to claim 4, wherein the monomeric, oligomeric and/or polymeric precursors comprise an epoxy group.

6. The formulation according to claim 5, wherein the passivation material comprises at least one of a crosslinking agent, a photoacid generator, a hardener and an antioxidant.

7. The formulation according to any one of claims 4 to 6, wherein the monomeric, oligomeric and/or polymeric precursors comprise (alkyl)acrylate repeating units.

8. The formulation according to any one of claims 4 to 6, wherein the monomeric, oligomeric and/or polymeric precursors are cross-linkable via a thiol-ene or a thiol (alkyl)acrylate reaction.

9. The formulation according to any one of claims 4 to 6, wherein the monomeric, oligomeric and/or polymeric precursors are cross-linkable via a thermal azide alkyne cycloaddition reaction.

10. The formulation according to any one of claims 3 to 6, wherein the cross-linkable composition comprises a polyimide.

11. The formulation according to any one of claims 3 to 6, wherein the cross-linkable composition comprises a cycloolefinic polymer.

12. The formulation according to any one of claims 3 to 6, wherein the cross-linkable composition comprises a substituted poly(vinylphenol) derivative.

13. The formulation according to claim 1, comprising at least one of a crosslinking agent, a photoacid generator, a hardener, an antioxidant, a surfactant and a filler.

14. The formulation according to claim 1, further comprising a cosolvent.

15. A method of fabricating an organic electronic (OE) device comprising an organic layer, wherein the organic layer is selected from an organic semiconductor (OSC) layer and an organic gate insulator (OGI) layer, and wherein the method comprises:
providing a passivation layer on at least a part of the organic layer by depositing a formulation according to any one of claims 1 to 14 thereon and removing the solvent.

16. An organic electronic (OE) device comprising an organic layer and a passivation layer directly thereon, wherein the organic layer is selected from an organic semiconductor (OSC) layer and an organic gate insulator (OGI) layer, and wherein the passivation layer is made from the formulation according to any one of claims 1 to 14.

17. The organic electronic (OE) device according to claim 16, wherein the organic electronic (OE) device is selected from an organic field effect transistor (OFET) device, wherein one of the source or drain electrodes does not completely surround the other.

18. The organic electronic (OE) device according to claim 16, wherein overlap of a gate metal with source and drain electrodes is less than 5 microns.

19. A product comprising an organic electronic (OE) device according to any one of claims 16 to 18.

20. A flowable formulation comprising a photopatterning material and a solvent;
wherein the solvent comprises lactate and/or a derivative thereof.

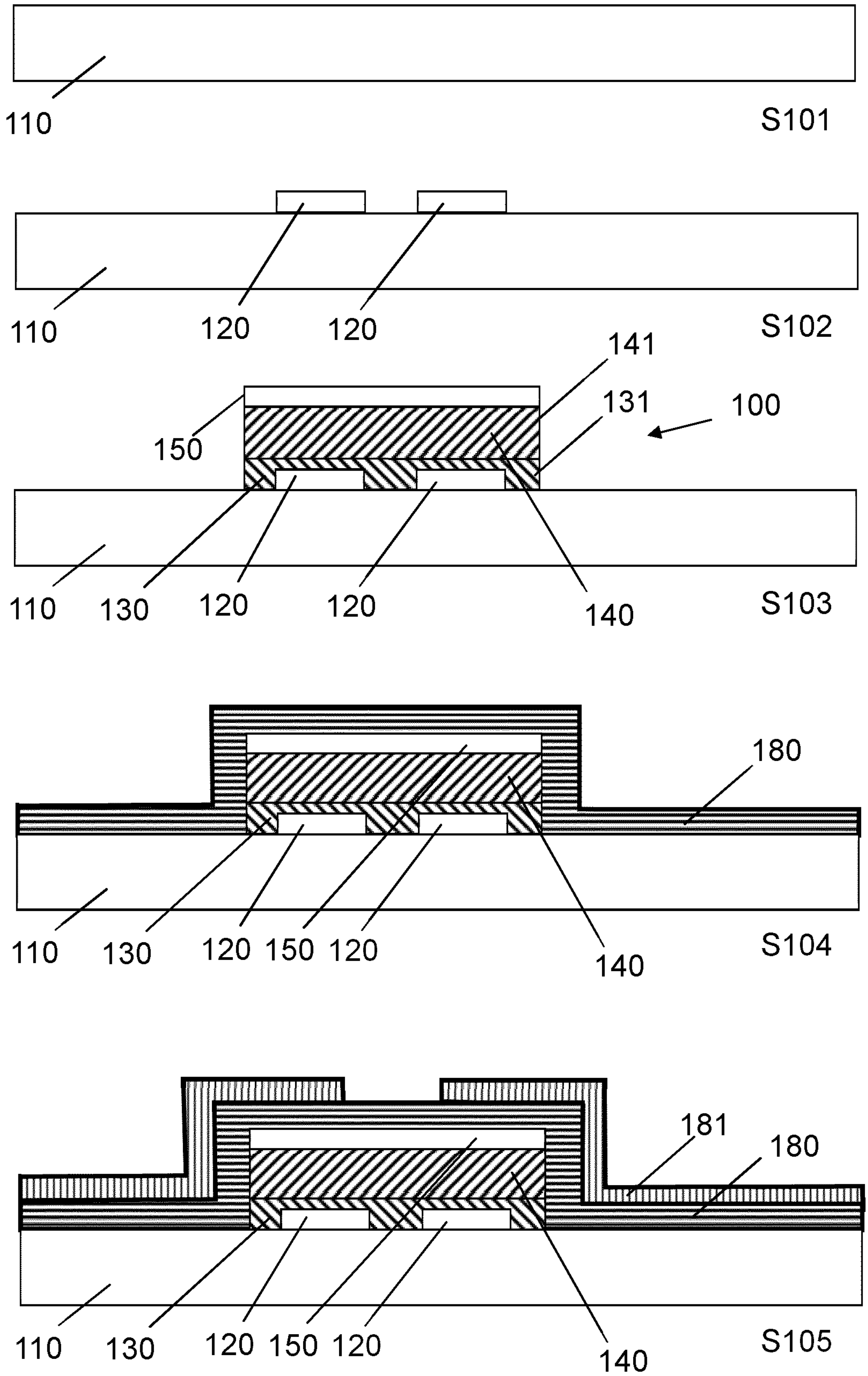
110
S101
110
120
120
S102
141
131
100
150
110
130
120
120
140
S103
180
110
130
120
150
120
140
S104
181
180
110
130
120
150
120
140
S105

FIG. 1A

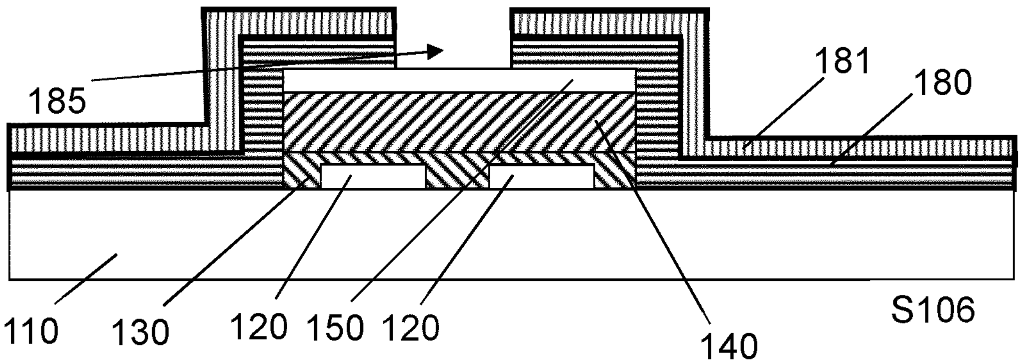
185
181
180
110
130
120
150
120
140
S106

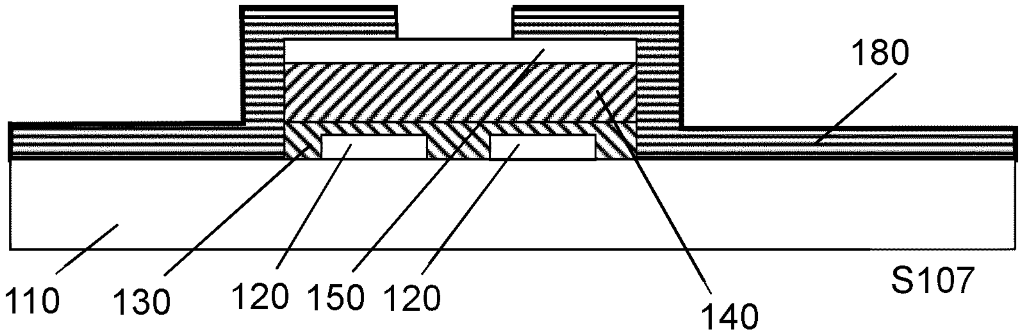
180
110
130
120
150
120
140
S107

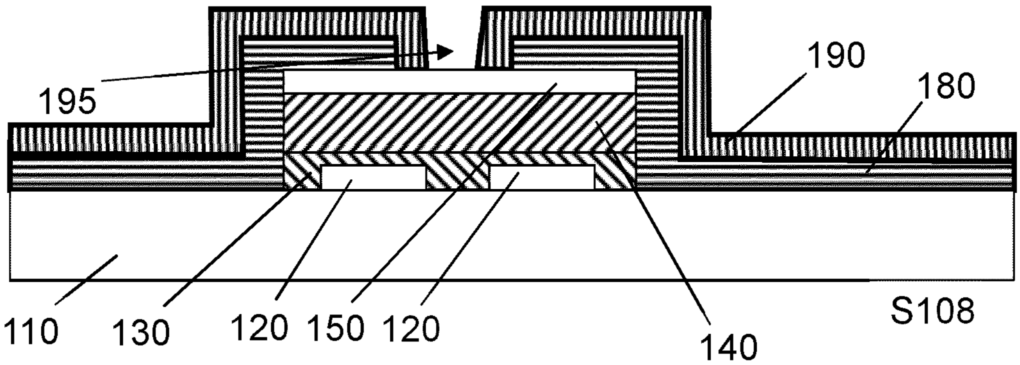
195
190
180
110
130
120
150
120
140
S108

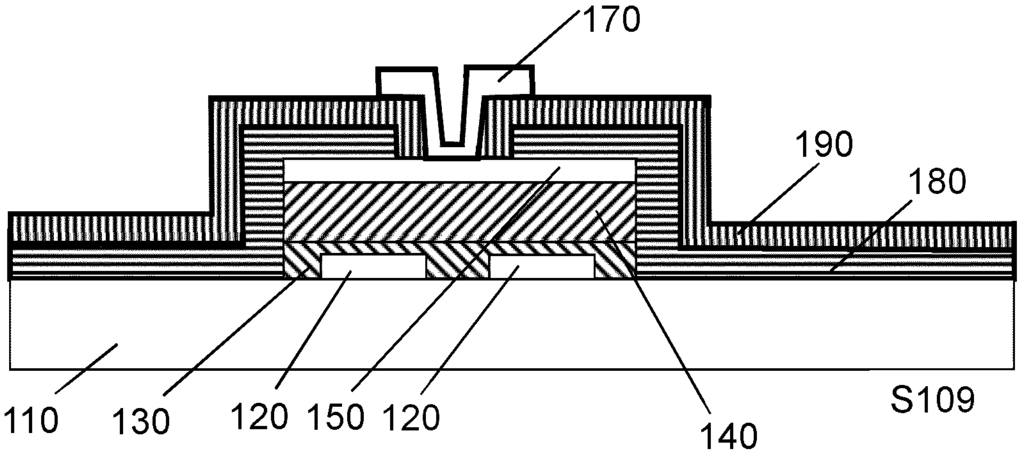
170
190
180
110
130
120
150
120
140
S109

FIG. 1B

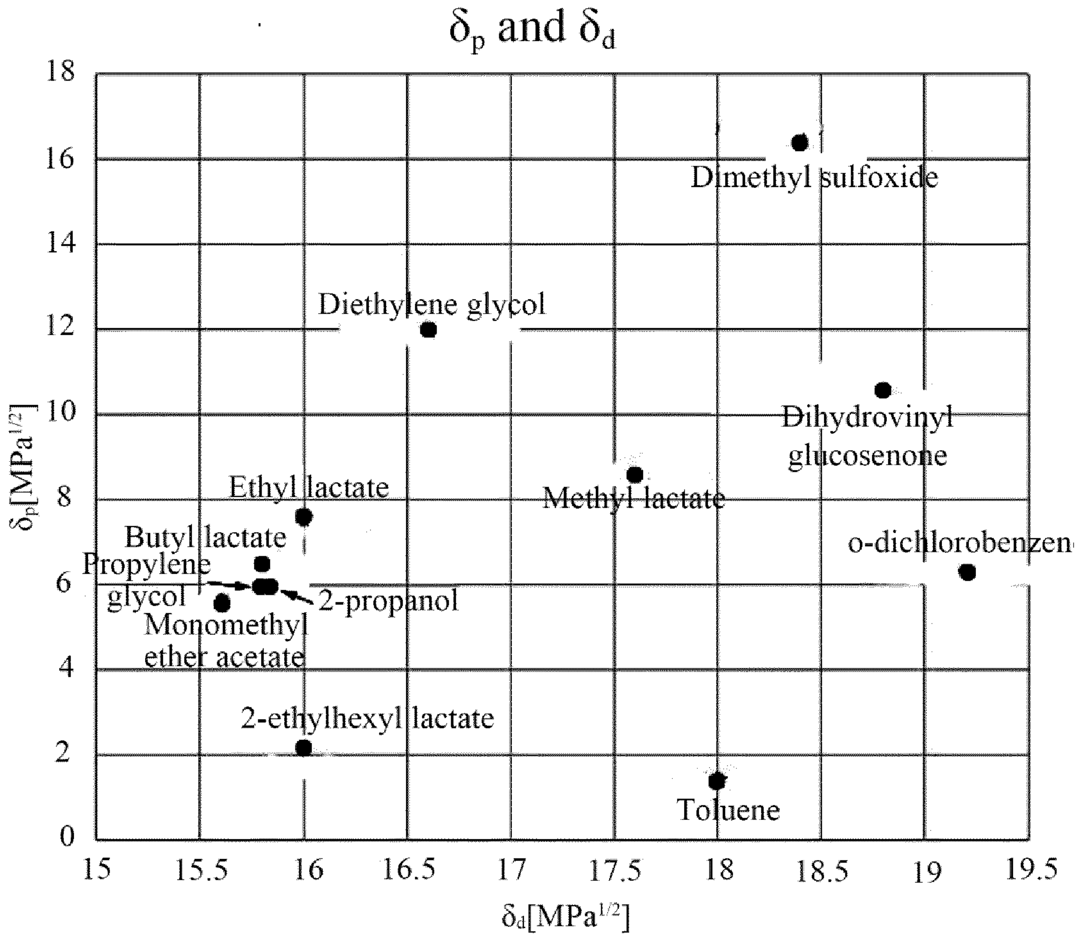
δp and δd
δp[MPa1/2]
δd[MPa1/2]
18
16
14
12
10
8
6
4
2
0
15
15.5
16
16.5
17
17.5
18
18.5
19
19.5
Dimethyl sulfoxide
Diethylene glycol
Dihydrovinyl glucosenone
Ethyl lactate
Methyl lactate
o-dichlorobenzen
Butyl lactate
Propylene glycol
2-propanol
Monomethyl ether acetate
2-ethylhexyl lactate
Toluene

FIG. 2A

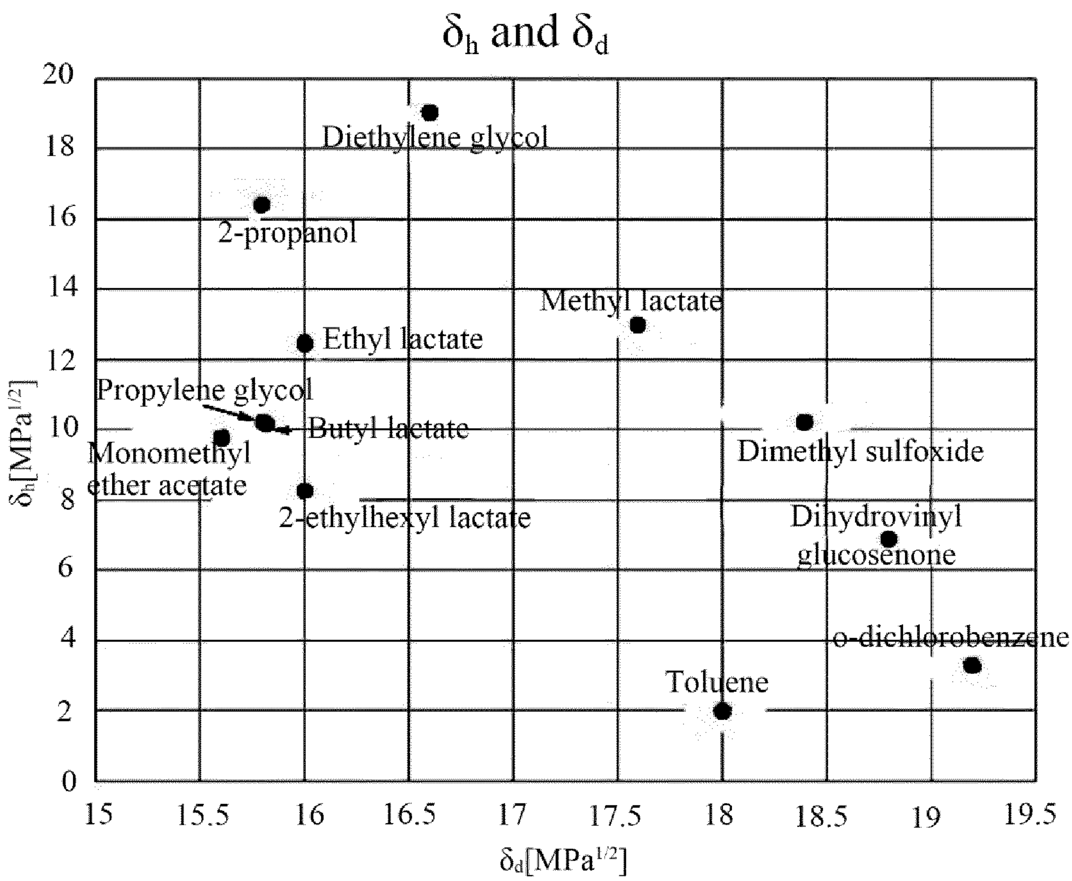
$\delta_h$ and $\delta_d$
20
18
16
14
12
10
8
6
4
2
0
15
15.5
16
16.5
17
17.5
18
18.5
19
19.5
$\delta_d$[MPa$^{1/2}$]
$\delta_h$[MPa$^{1/2}$]
Diethylene glycol
2-propanol
Methyl lactate
Ethyl lactate
Propylene glycol
Butyl lactate
Monomethyl
ether acetate
2-ethylhexyl lactate
Dimethyl sulfoxide
Dihydrovinyl
glucosenone
o-dichlorobenzene
Toluene

FIG. 2B

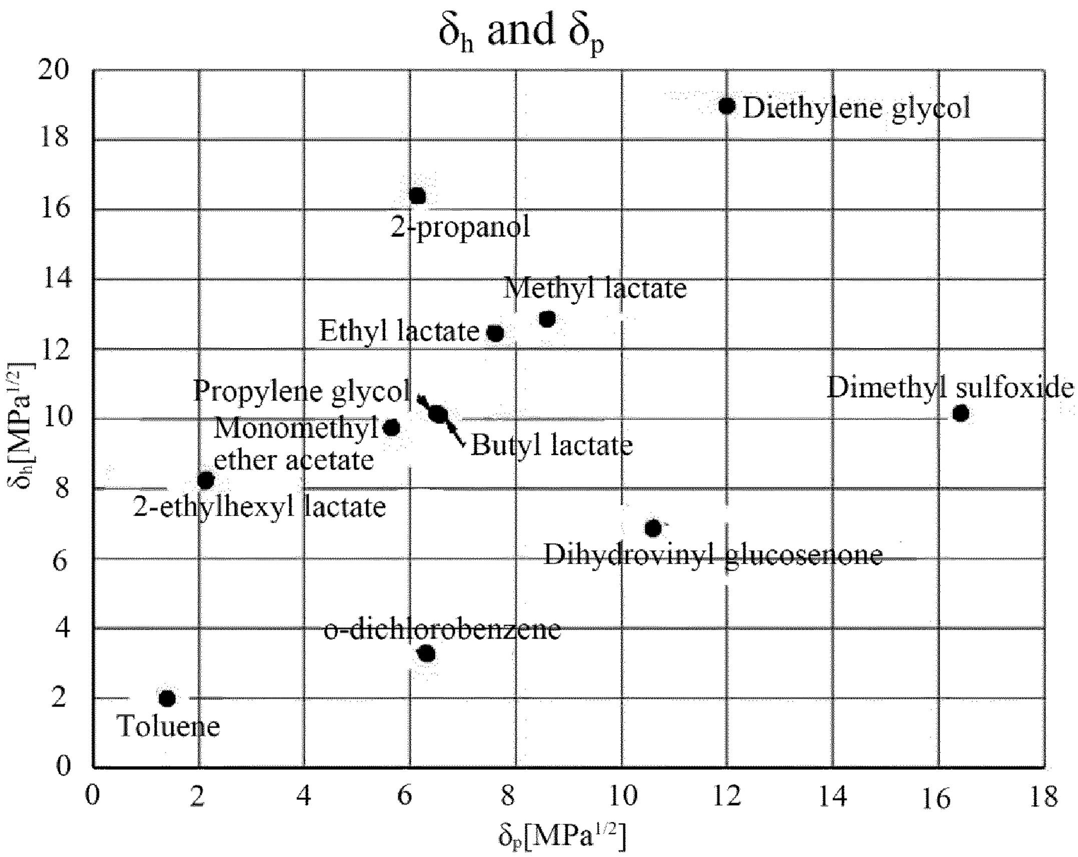
δh and δp
20
18
16
14
12
10
8
6
4
2
0
δh[MPa1/2]
0
2
4
6
8
10
12
14
16
18
δp[MPa1/2]
Diethylene glycol
2-propanol
Methyl lactate
Ethyl lactate
Dimethyl sulfoxide
Propylene glycol
Monomethyl
ether acetate
Butyl lactate
2-ethylhexyl lactate
Dihydrovinyl glucosenone
o-dichlorobenzene
Toluene

FIG. 2C

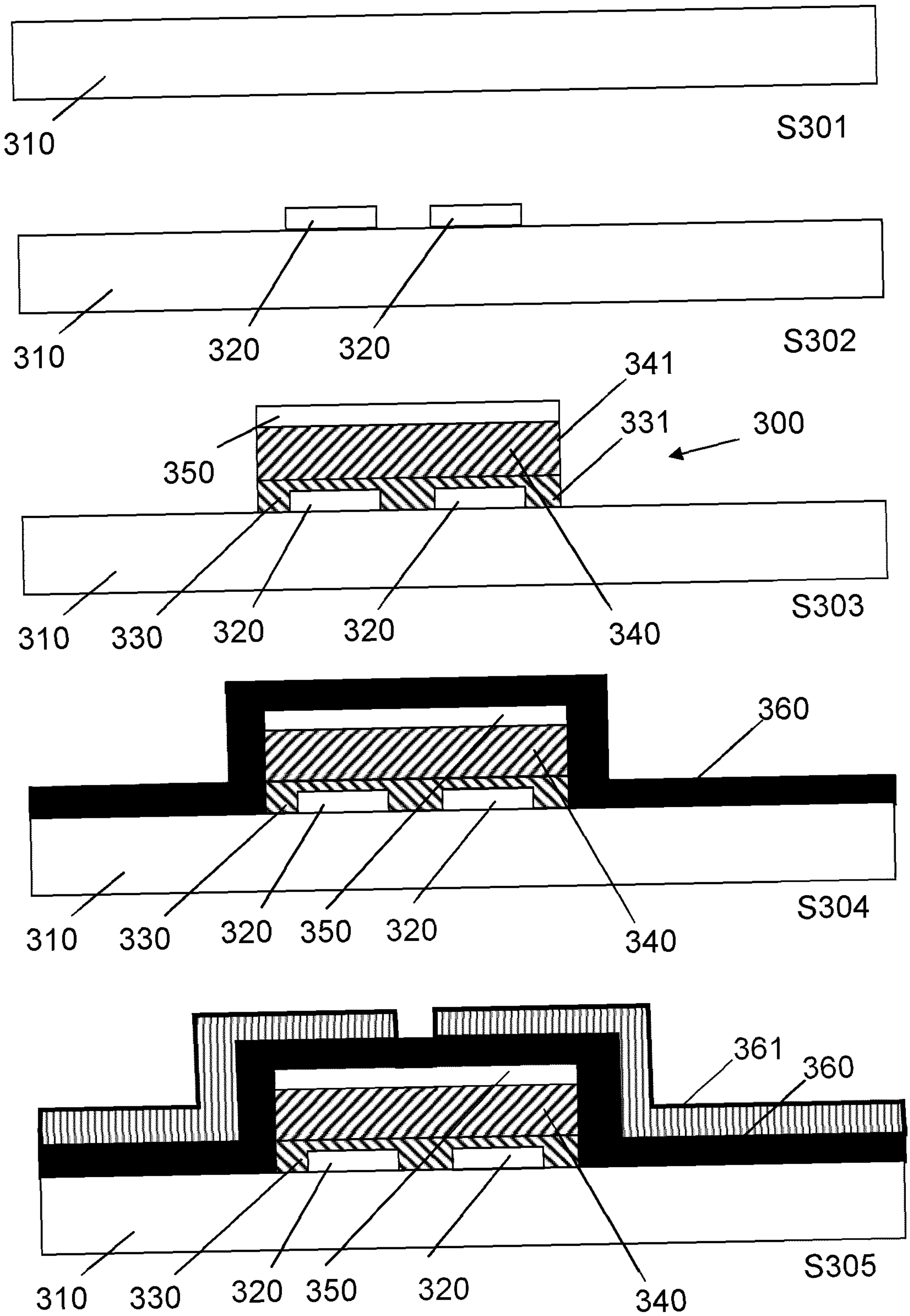
310
S301
320
320
310
S302
341
331
300
350
310
330
320
320
340
S303
360
310
330
320
350
320
340
S304
361
360
310
330
320
350
320
340
S305

FIG. 3A

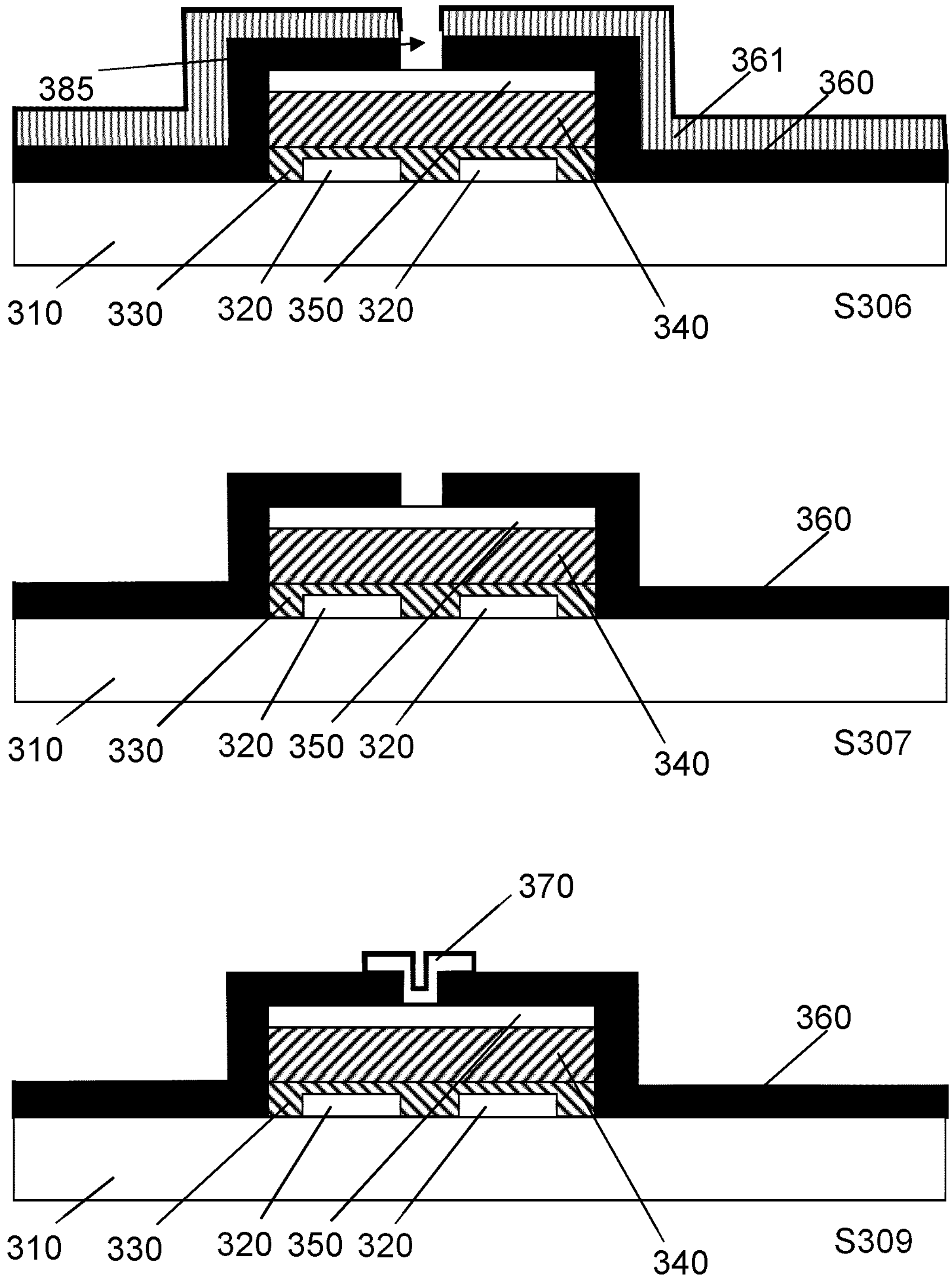
385
361
360
310
330
320
350
320
340
S306
360
310
330
320
350
320
340
S307
370
360
310
330
320
350
320
340
S309

FIG. 3B

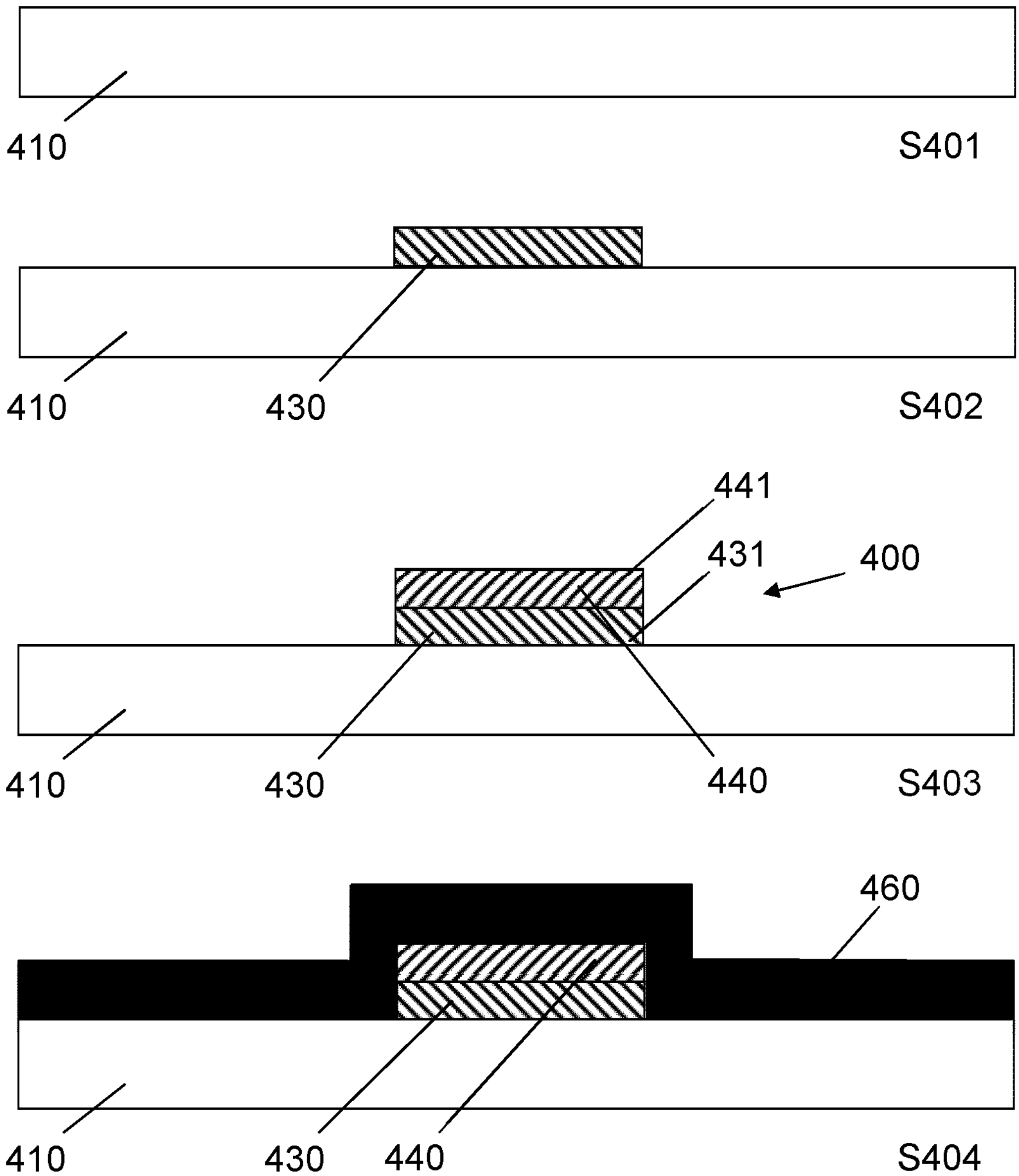
410
S401
410
430
S402
441
431
400
410
430
440
S403
460
410
430
440
S404

FIG. 4

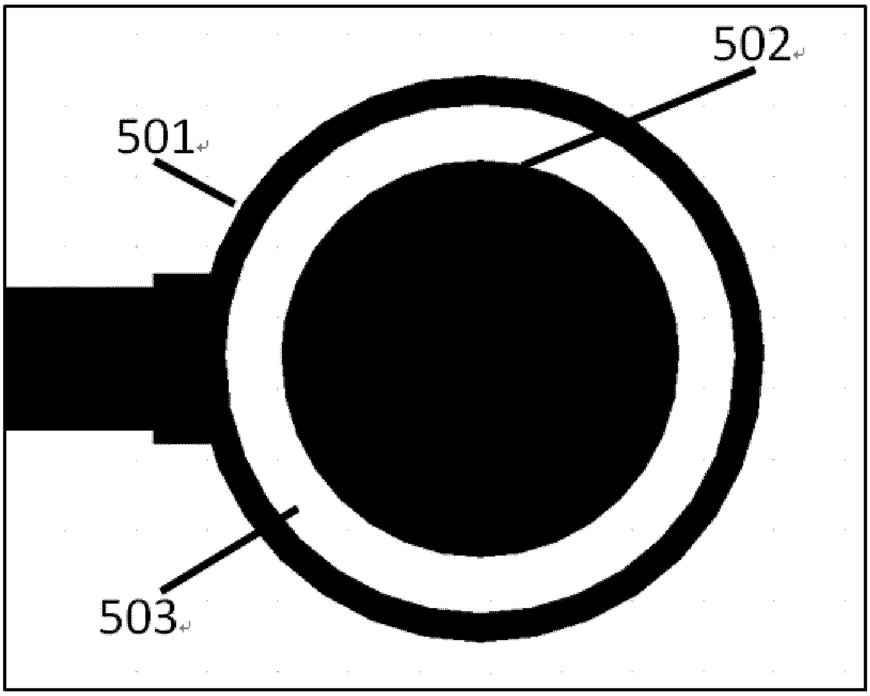


FIG. 5A

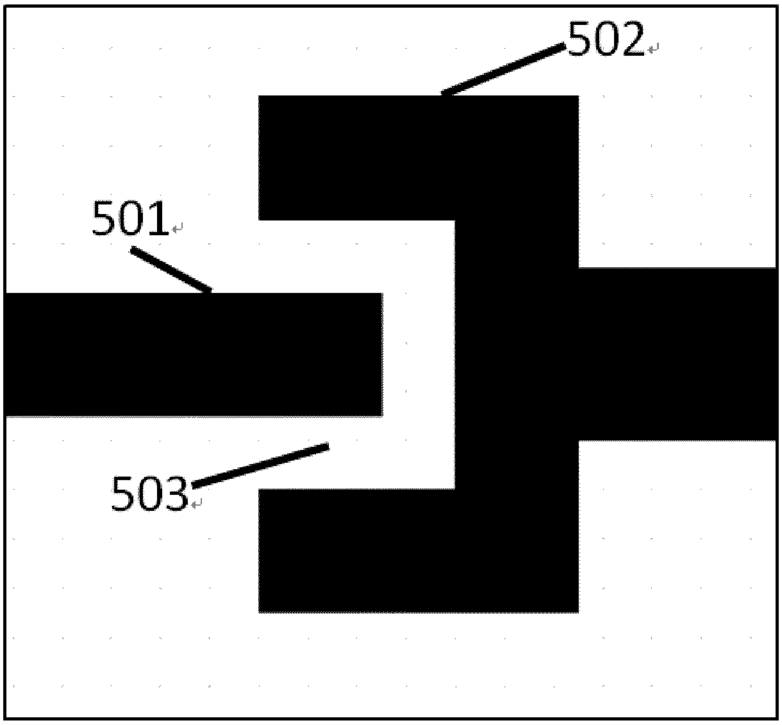


FIG. 5B

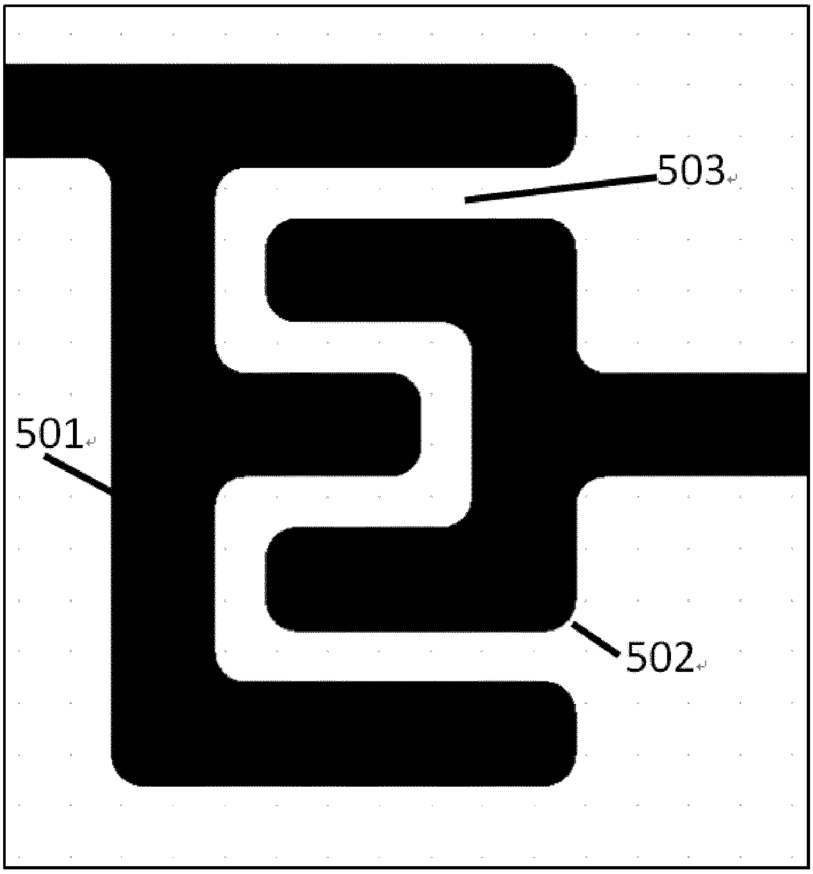


FIG. 5C

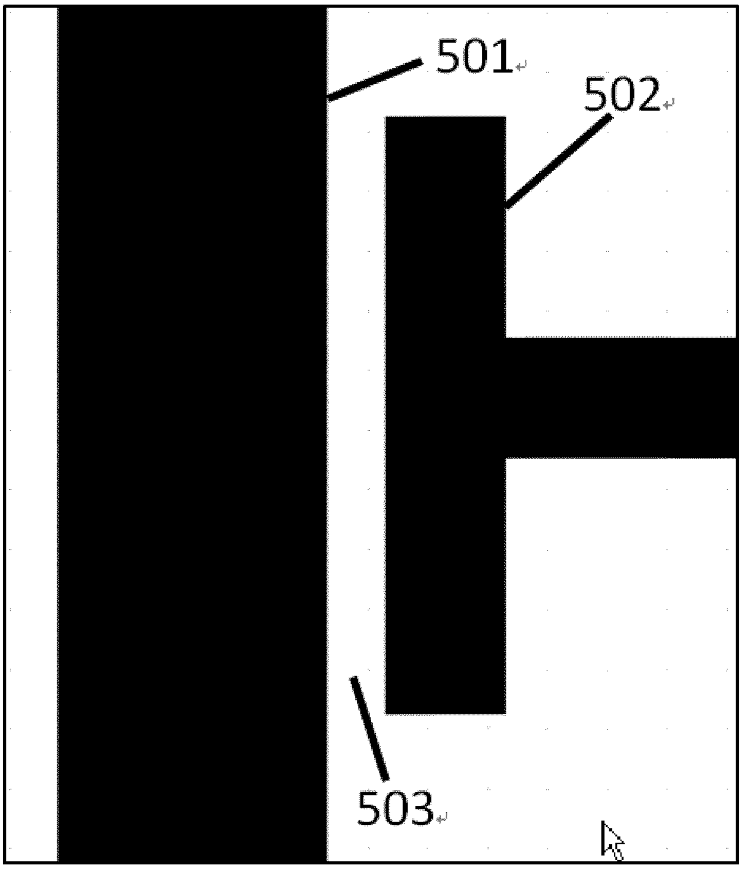


FIG. 5D

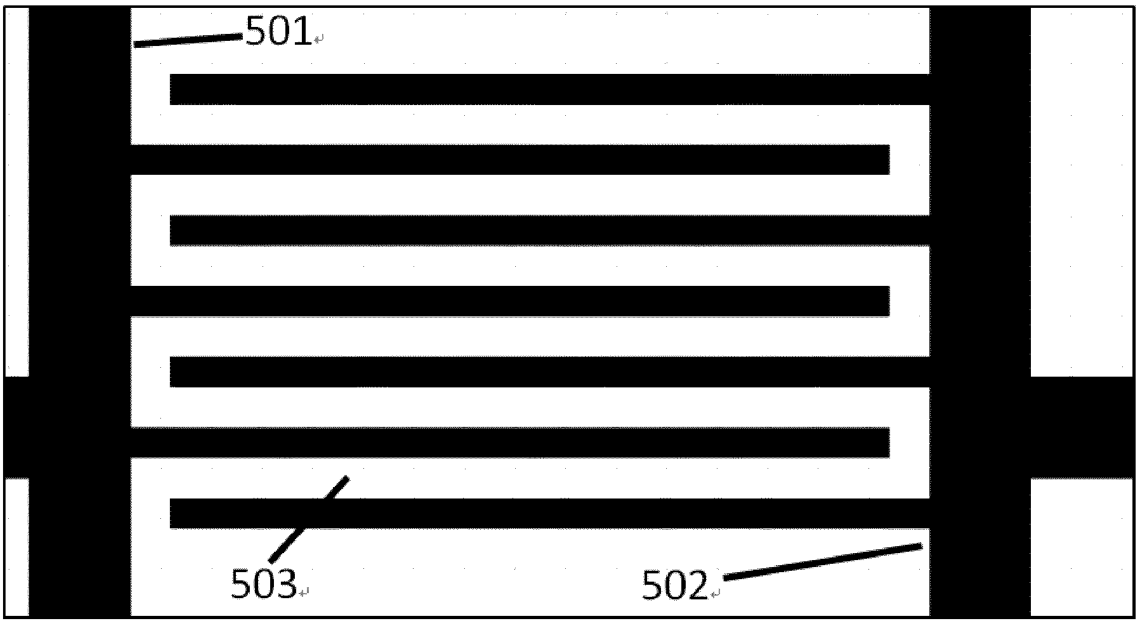


FIG. 5E

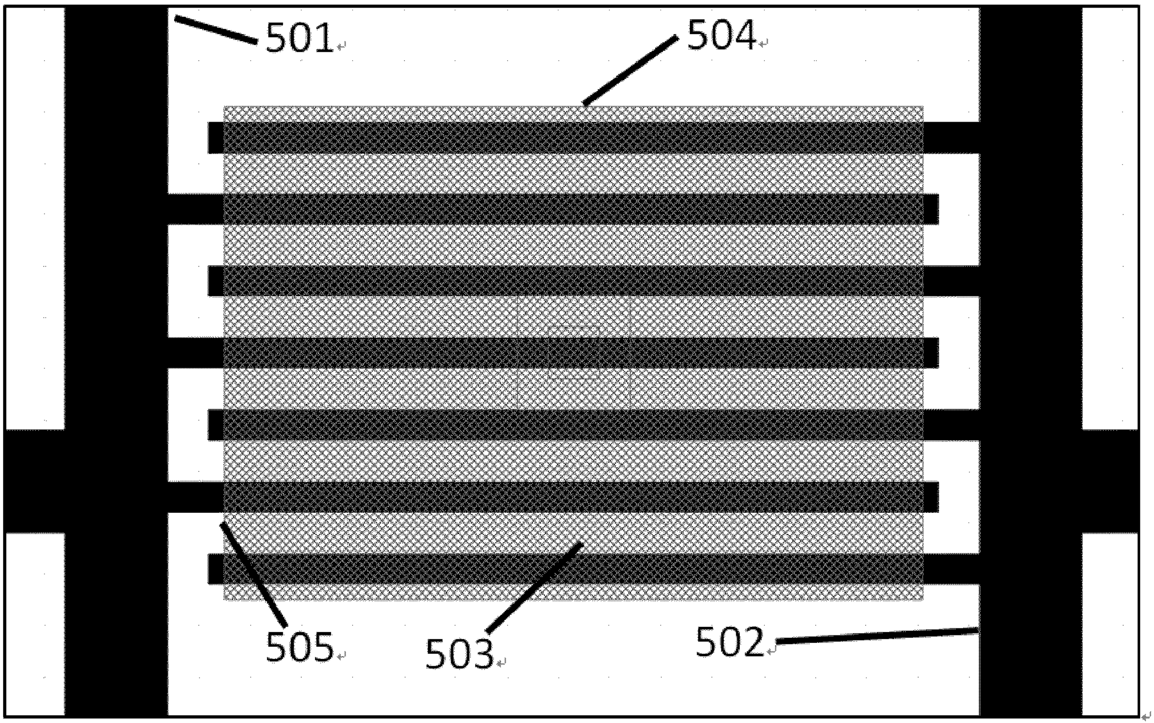


FIG. 5F

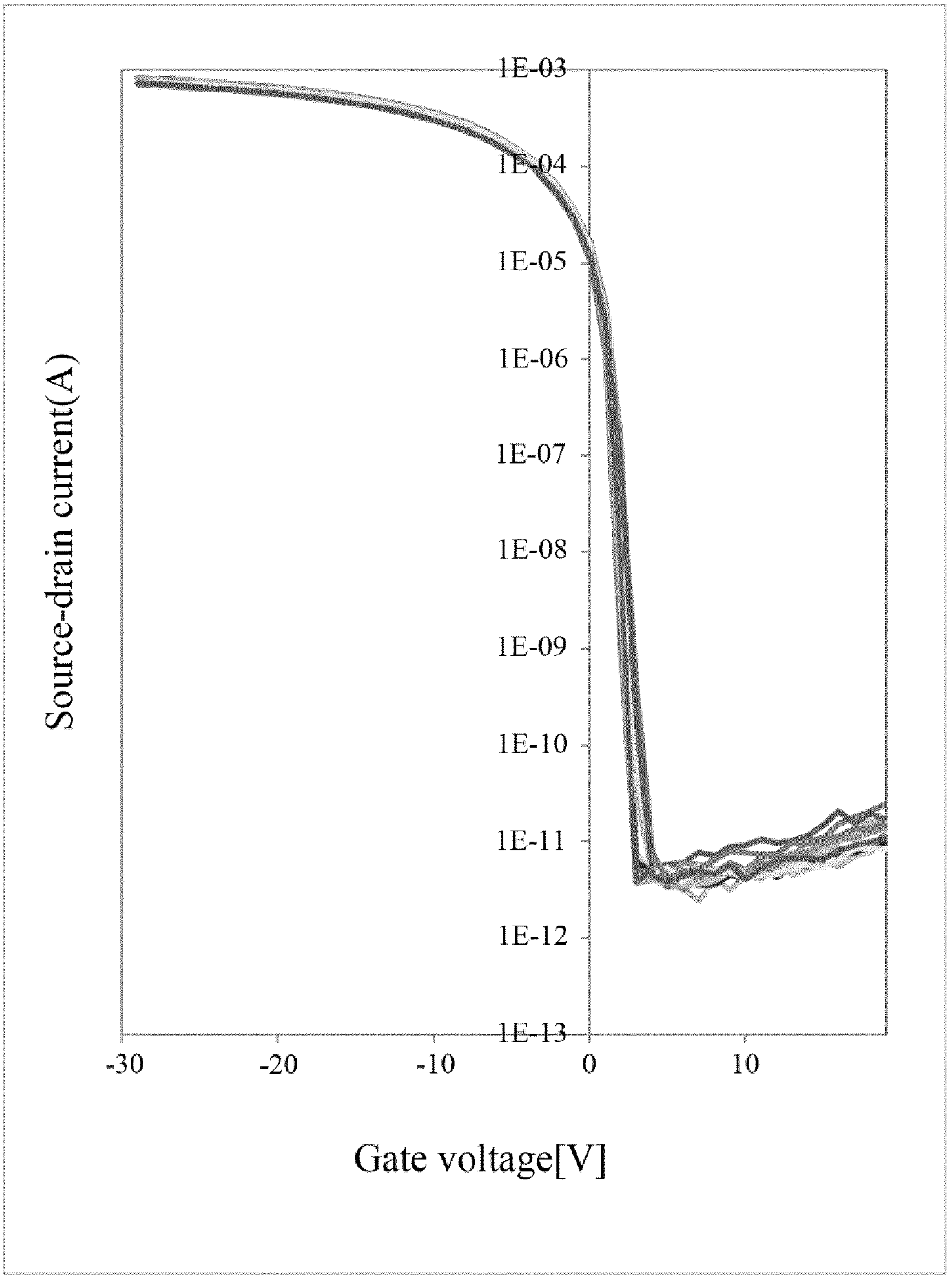
Source-drain current(A)
1E-03
1E-04
1E-05
1E-06
1E-07
1E-08
1E-09
1E-10
1E-11
1E-12
1E-13
-30
-20
-10
0
10
Gate voltage[V]

FIG. 6A

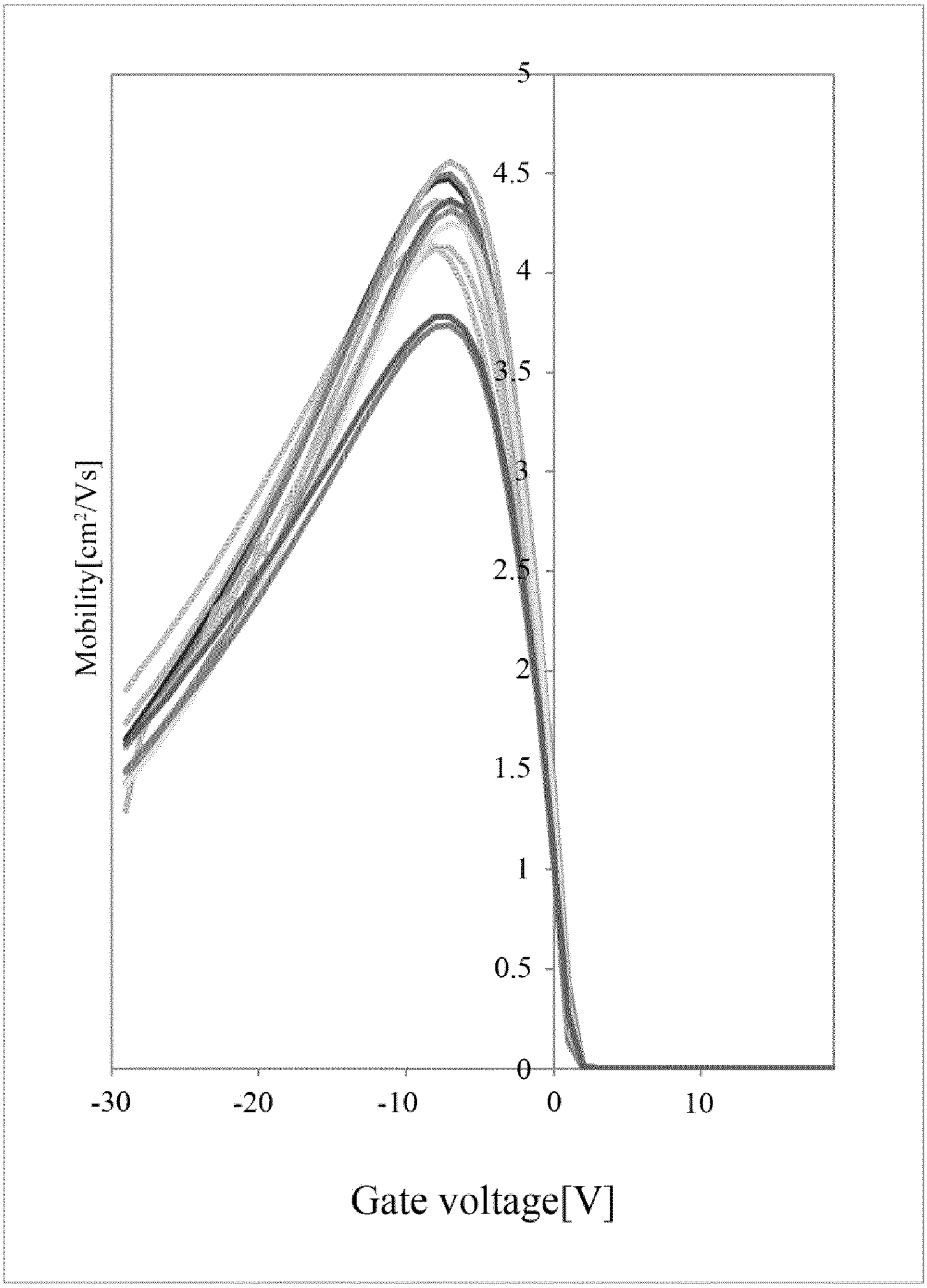
Mobility[cm²/Vs]
5
4.5
4
3.5
3
2.5
2
1.5
1
0.5
0
-30
-20
-10
0
10
Gate voltage[V]

FIG. 6B

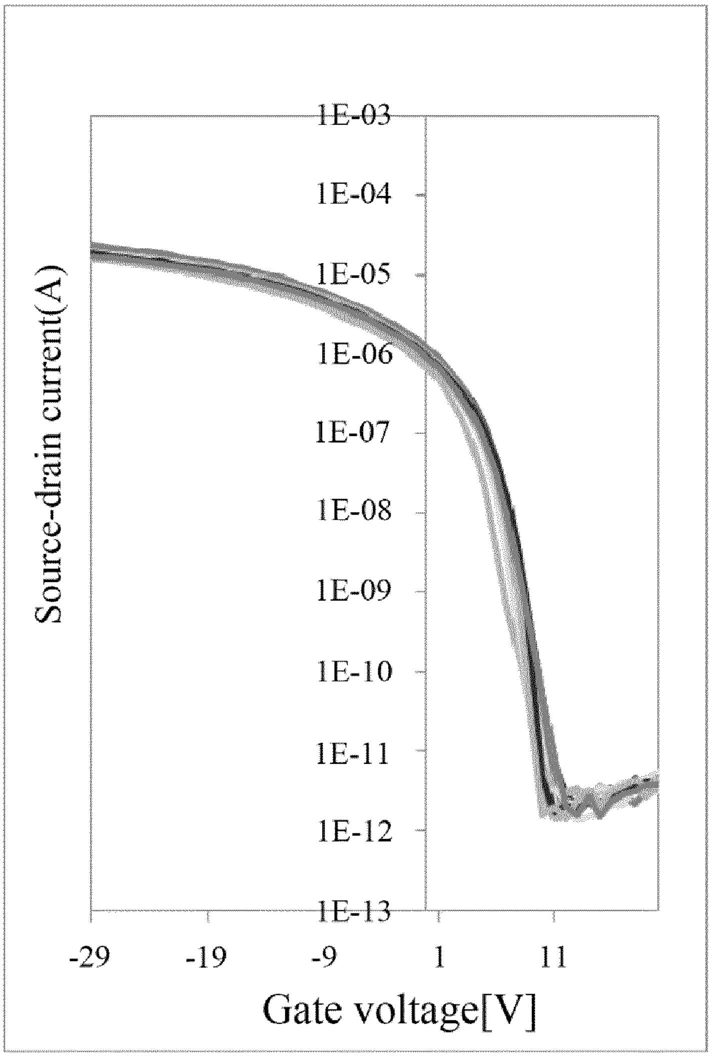
1E-03
1E-04
1E-05
1E-06
1E-07
1E-08
1E-09
1E-10
1E-11
1E-12
1E-13
Source-drain current(A)
-29
-19
-9
1
11
Gate voltage[V]

FIG. 6C

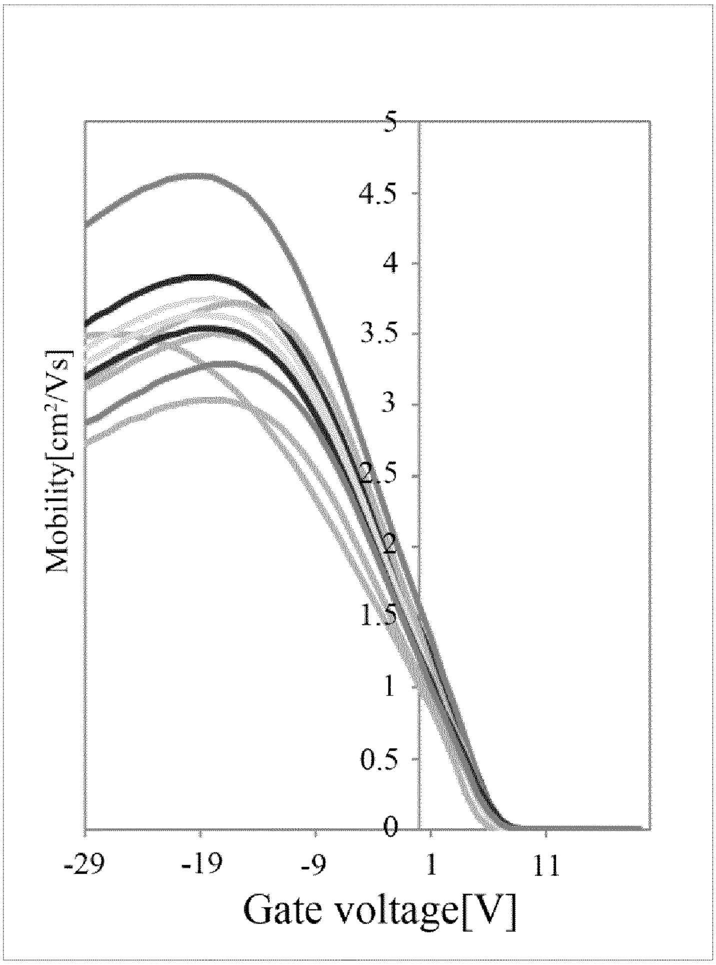


FIG. 6D

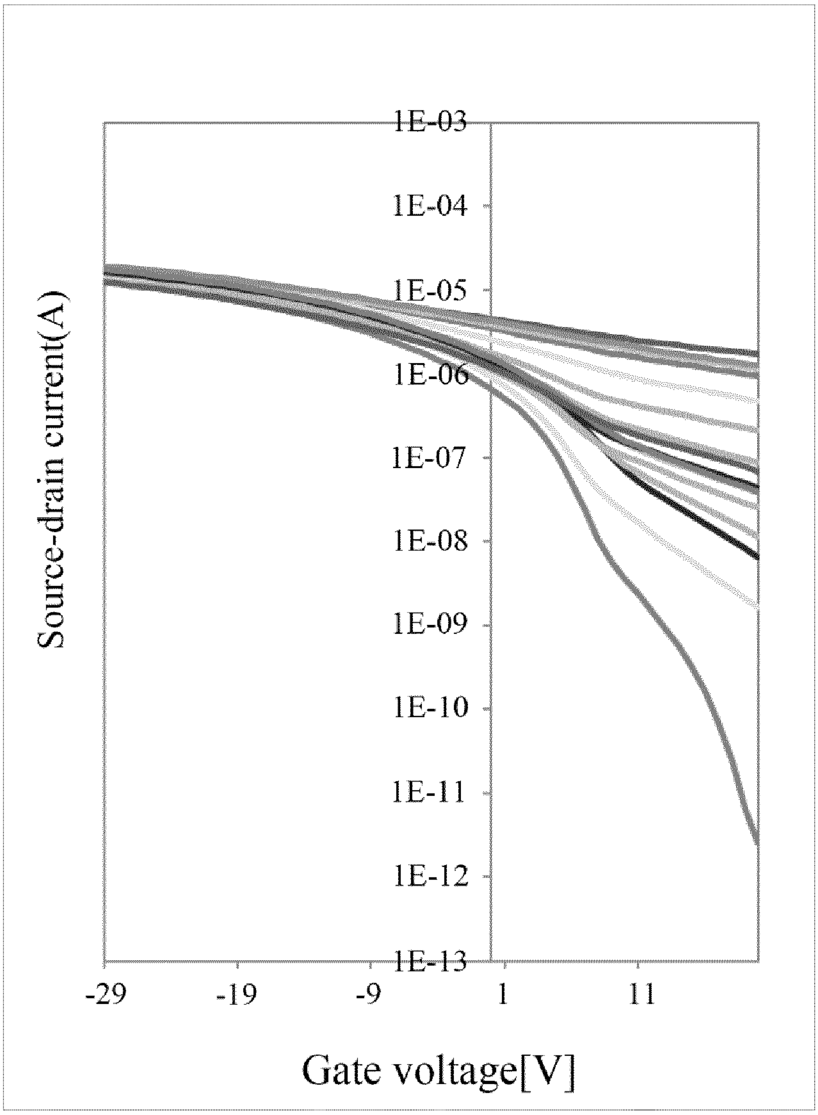
1E-03
1E-04
1E-05
1E-06
1E-07
1E-08
1E-09
1E-10
1E-11
1E-12
1E-13
Source-drain current(A)
-29
-19
-9
1
11
Gate voltage[V]

FIG. 7A

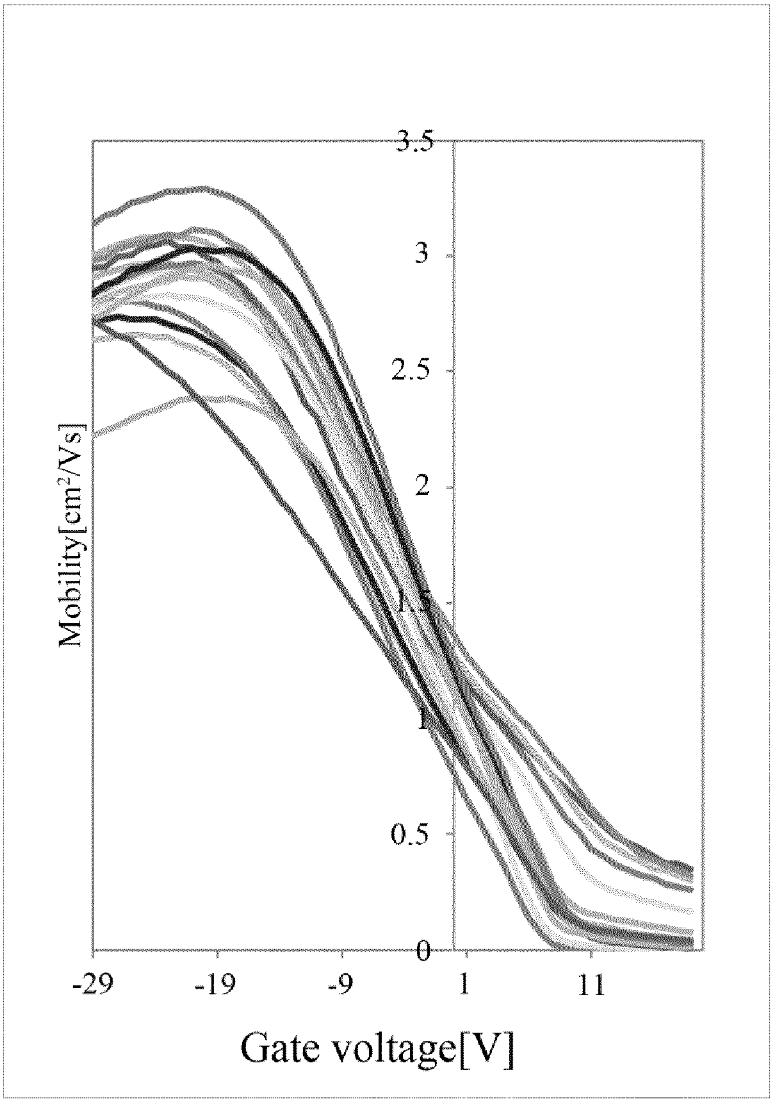


FIG. 7B

## INTERNATIONAL SEARCH REPORT

International application No.
**PCT/CN2020/070696**

**A. CLASSIFICATION OF SUBJECT MATTER**

H01L 51/05(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

WPI, EPODOC, CNPAT, CNKI: 纽多维, 有机, 电子, 器件, 半导体, 溶剂, SU8, 乳酸, 钝化层, 交联, organic, electric+, device, semiconductor, solvent, passivat+, barrier, lactate, crosslink+

**C. DOCUMENTS CONSIDERED TO BE RELEVANT**

| Category* | Citation of document, with indication, where appropriate, of the relevant passages | Relevant to claim No. |
|---|---|---|
| X | CN 104221177 A (POLYERA CORP.) 17 December 2014 (2014-12-17) description, paragraphs [0009], [0016], [0017], [0115]-[0117], [0142], [0155], [0157], [0216], and figures 1 and 2 | 1-20 |
| A | CN 105555822 A (POLYERA CORP.) 04 May 2016 (2016-05-04) entire document | 1-20 |
| A | US 8975110 B2 (SAMSUNG ELECTRONICS CO., LTD.) 10 March 2015 (2015-03-10) entire document | 1-20 |
| A | WO 2008124711 A1 (HONEYWELL INTERNATIONAL INC. et al.) 16 October 2008 (2008-10-16) entire document | 1-20 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 March 2020** | **26 March 2020** |
| Name and mailing address of the ISA/CN<br>**China National Intellectual Property Administration (ISA/CN)**<br>**No. 6, Xitucheng Road, Jimenqiao Haidian District, Beijing 100088**<br>**China** | Authorized officer |
| Facsimile No. **(86-10)62019451** | Telephone No. |

Form PCT/ISA/210 (second sheet) (January 2015)

**INTERNATIONAL SEARCH REPORT**
**Information on patent family members**

International application No.
**PCT/CN2020/070696**

| Patent document cited in search report | Publication date (day/month/year) | Patent family member(s) | Publication date (day/month/year) |
|---|---|---|---|
| CN 104221177 A | 17 December 2014 | WO 2013119717 A1 | 15 August 2013 |
| | | TW 201339182 A | 01 October 2013 |
| | | EP 2812931 B1 | 13 June 2018 |
| | | TW I589602 B | 01 July 2017 |
| | | CN 104221177 B | 29 March 2017 |
| | | JP 6161636 B2 | 12 July 2017 |
| | | JP 2015513215 A | 30 April 2015 |
| | | KR 20140127310 A | 03 November 2014 |
| | | EP 2812931 A1 | 17 December 2014 |
| | | US 2013200345 A1 | 08 August 2013 |
| | | US 8878169 B2 | 04 November 2014 |
| CN 105555822 A | 04 May 2016 | WO 2015009768 A1 | 22 January 2015 |
| | | US 9190493 B2 | 17 November 2015 |
| | | CN 105555822 B | 08 May 2018 |
| | | US 2016190337 A1 | 30 June 2016 |
| | | US 9704997 B2 | 11 July 2017 |
| | | US 2015021597 A1 | 22 January 2015 |
| US 8975110 B2 | 10 March 2015 | KR 20110118899 A | 02 November 2011 |
| | | US 2011263136 A1 | 27 October 2011 |
| WO 2008124711 A1 | 16 October 2008 | TW I500702 B | 21 September 2015 |
| | | JP 2017110193 A | 22 June 2017 |
| | | TW I588211 B | 21 June 2017 |
| | | KR 20100016423 A | 12 February 2010 |
| | | TW 200900468 A | 01 January 2009 |
| | | KR 101459316 B1 | 12 November 2014 |
| | | KR 20140063910 A | 27 May 2014 |
| | | JP 2010532792 A | 14 October 2010 |
| | | JP 6322068 B2 | 09 May 2018 |
| | | JP 2014208838 A | 06 November 2014 |
| | | KR 101494614 B1 | 24 February 2015 |
| | | TW 201531532 A | 16 August 2015 |
| | | US 2011171447 A1 | 14 July 2011 |
| | | US 8901268 B2 | 02 December 2014 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2013225711 A1
- WO 2013119717 A1
- EP 2524947 A1
- US 9082981 B
- WO 2013120581 A
- WO 2013119717 A
- WO 2012164282 A
- US 20030116755 A
- US 3557233 A
- US 6690029 B
- WO 2007078993 A
- WO 2008128618 A
- WO 2012160383 A
- WO 2005055248 A

### Non-patent literature cited in the description

- *J Appl Polymer Sci,* 2013, vol. 39968, 1-7
- *ACS Applied Materials Interfaces,* 2009, vol. 1 (7), 1585
- *J Sol Gel Sci Technol,* 2012, vol. 61 (2), 321
- *Chem Mater,* 2013, vol. 25, 4806
- **SHENGXIA LI ; WEI TANG ; WEIMIN ZHANG ; XIAOJUN GUO ; QING ZHANG.** Cross-linked Polymer-Blend Gate Dielectrics through Thermal Click Chemistry. *Chem. Eur. J.,* 2015, vol. 21, 17762-17768
- *J. Mater. Chem. C,* 2014
- Handbook of Polymer Coatings for Electronics: Chemistry, Technology and Applications. 55-65
- *Chem Mater,* 2015, vol. 25, 4806
- *Materials,* 2009, vol. 2, 1697-1733
- *Organic Letters,* 2004, vol. 6 (10), 1609-1612